(19)

Europäisches Patentamt
European Patent Office
Office européen des brevets

(11) **EP 1 962 450 A1**

(12) **EUROPEAN PATENT APPLICATION**
published in accordance with Art. 158(3) EPC

(43) Date of publication:
  **27.08.2008 Bulletin 2008/35**

(21) Application number: **06822754.5**

(22) Date of filing: **01.11.2006**

(51) Int Cl.:
  *H04L 1/00* (2006.01)    *H03M 13/47* (2006.01)
  *H04L 1/18* (2006.01)

(86) International application number:
  **PCT/JP2006/321825**

(87) International publication number:
  **WO 2007/069406 (21.06.2007 Gazette 2007/25)**

(84) Designated Contracting States:
  **DE FR GB**

(30) Priority: **15.12.2005 JP 2005362277**

(71) Applicant: **Mitsubishi Electric Corporation**
  **Chiyoda-ku**
  **Tokyo**
  **100-8310 (JP)**

(72) Inventors:
  • **UCHIDA, Shigeru**
   **Chiyoda-ku, Tokyo 1008310 (JP)**

  • **KUZE, Toshiyuki**
   **Chiyoda-ku, Tokyo 1008310 (JP)**
  • **MATSUMOTO, Wataru**
   **Chiyoda-ku, Tokyo 1008310 (JP)**
  • **TAIRA, Akinori**
   **Chiyoda-ku, Tokyo 1008310 (JP)**
  • **NAGAI, Yukimasa**
   **Chiyoda-ku, Tokyo 1008310 (JP)**

(74) Representative: **Pfenning, Meinig & Partner GbR**
  **Patent- und Rechtsanwälte**
  **Theresienhöhe 13**
  **80339 München (DE)**

(54) **COMMUNICATION SYSTEM, TRANSMISSION-SIDE COMMUNICATION DEVICE, AND RECEPTION-SIDE COMMUNICATION DEVICE**

(57)   Within a communication system in which an ARQ control is exercised, in a transmission-side communication apparatus 11, a transmission scheduling unit 113 determines a transmission amount to be transmitted to a reception-side communication apparatus 21; an erasure correction encoding unit 112 performs an erasure correction encoding process on an information packet group that is made up of a plurality of packets to be transmitted so as to generate one or more erasure correction coded packets that fit the transmission amount instructed by the transmission scheduling unit 113 and specifies the one or more erasure correction coded packets as a unit of delivery confirmation; and a modulating unit 115 transmits a transmission data signal that has been generated by performing a predetermined modulation process on each of the erasure correction coded packets. In the reception-side communication apparatus 21, an erasure correction decoding unit 213 generates the information packet group by performing an erasure correction decoding process on the received signal and also generates, in the case where the erasure correction decoding process has successfully been performed, a delivery confirmation signal for each unit of delivery confirmation, the delivery confirmation signal indicating that reception of the transmission data signal has been completed, so that the generated delivery confirmation signal is transmitted to the transmission-side communication apparatus 11.

FIG.1

**Description**

TECHNICAL FIELD

The present invention relates to a communication system that uses an Automatic Repeat reQuest (ARQ) method in which the reception side automatically makes a request to the transmission side that transmission data should be re-transmitted, and also relates to a transmission-side communication apparatus and a reception-side communication apparatus that are included in such a communication system.

BACKGROUND ART

Various types of the ARQ method mentioned above have conventionally been considered, and in particular, typical examples are as follows:

(1) Stop-and-wait (SAW) ARQ method
(2) Go-Back-N (GBN) ARQ method
(3) Selective Repeat (SR) ARQ method

The SAW_ARQ method is characterized in that a delivery confirmation is made for each transmission block, and a new block is not transmitted until an ACK is returned from the reception side. The SAW_ARQ method is also used in a Media Access Control (MAC) layer according to the Institute of Electrical and Electronics Engineers, Inc. (IEEE) 802.11 standard. Although the SAW_ARQ method is simple, it is disadvantageous in that the transmission efficiency is low, and user throughput relative to the capacity of the communication line is not sufficient.

The GBN_ARQ method is characterized in that transmission blocks continue to be transmitted even if no ACK is received from the reception side, but when an NACK is returned from the reception side, the continual transmission is resumed from a corresponding sequence number. Although the GBN_ARQ method is also simple, it is disadvantageous in that the transmission efficiency is significantly degraded in a communication environment like a wireless communication line where communication errors occur frequently.

In contrast, according to the SR_ARQ method, only the blocks in which an error has been detected on the reception side are re-transmitted. The SR_ARQ method is used as the ARQ method according to IEEE 802.16. The SR_ARQ method has advantageous characteristics where the transmission efficiency is high, and also, compared to the SAW_ARQ method and the GBN_ARQ method, it has a capability of preventing the user throughput from being degraded drastically, because the reception window is updated whenever it is necessary in correspondence with each piece of ACK/NACK information.

According to the basic ARQ methods explained above, when a reception error has occurred, the same data is re-transmitted as a means for recovering from the error. Thus, when the error rate of the transmission path becomes worse, the number of times the re-transmission process is performed increases. Thus, the throughput is significantly degraded. To improve the throughput for a transmission path having a bad error rate, an error correction code or an erasure correction code is used together with an ARQ method.

For instance, a representative example of an erasure correction code according to a conventional technique is a Luby Transfer (LT) code. A communication method that uses the LT code has a number of advantageous characteristics where a tentative communication path called an erasure communication path is set up, and a packet having a code length of n can arbitrarily be encoded on the transmission side with respect to a packet having an information length of k while n>k is satisfied, whereas as many information packets as k can successfully be decoded on the reception side even if only as few packets as n+ε at most (where ε ≈ 1.05xn to 1.2xn) have successfully been received (see, for example, Non-patent Document 1).

Non-patent Document 1: Michael Luby, "LT codes", in Proceedings of ACM Symposium on FOCS, 2002

DISCLOSURE OF INVENTION

PROBLEM TO BE SOLVED BY THE INVENTION

Even if the SR_ARQ method that has the highest throughput performance among the basic ARQ methods explained above is used as a means for controlling the re-transmission for a wireless communication line having a high speed and a large capacity, in a case where, for example, the communication line is in such a state that a re-transmission request is frequently made (including situations affected by delay in monitoring and adaptive control of communication line state information), or in a case where the system includes an uplink communication line used for a delivery confirmation that has a low level of performance although a downlink communication line having a large capacity is available, a problem arises, for example, the user throughput is significantly degraded temporarily because the update of the ARQ transmission window is delayed.

In view of the problems explained above, it is an object of the present invention to provide a communication system, a transmission-side communication apparatus, and a reception-side communication apparatus that are able to avoid or inhibit a temporary and drastic degradation of the user throughput, even when they are applied to, for example, a communication system that has a possibility of experiencing such a state of communication line in which a re-transmission request is frequently made.

MEANS FOR SOLVING PROBLEM

To solve the problems as described above and to achieve an object, a communication system according to the present invention is a communication system in which a reception-side communication apparatus makes a request to a transmission-side communication apparatus that a transmission data signal be re-transmitted, wherein the transmission-side communication apparatus includes a transmission scheduling unit that determines a transmission amount to be transmitted, at least, to the reception-side communication apparatus, an erasure correction encoding unit that performs an erasure correction encoding process on an information packet group that is made up of a plurality of packets to be transmitted so as to generate one or more erasure correction coded packets that fit the transmission amount instructed by the transmission scheduling unit and specifies the one or more erasure correction coded packets as a unit of delivery confirmation, and a transmitting unit that transmits the transmission data signal that has been generated by performing a predetermined modulation process on each of the erasure correction coded packets, and the reception-side communication apparatus includes an erasure correction decoding unit that generates the information packet group by performing an erasure correction decoding process on the transmission data signal that has been received and generates, in a case where the erasure correction decoding process has successfully been performed on the transmission data signal, a reception completion signal indicating that reception of the transmission signal has been completed for each unit of delivery confirmation, and a transmitting unit that transmits a delivery confirmation signal that has been generated based on the reception completion signal.

EFFECT OF THE INVENTION

According to the present invention, in the transmission-side communication apparatus, the erasure correction encoding process is performed on the information packet group that is made up of the plurality of packets to be transmitted, so that the one or more erasure correction coded packets that fit the predetermined transmission amount are generated. The one or more erasure correction coded packets are specified as one of units in which a delivery confirmation is made (hereinafter "a unit of delivery confirmation") and are transmitted to the reception-side communication apparatus. In the reception-side communication apparatus, the information packet group is generated by performing the erasure correction decoding process on the received signal. In the case where the erasure correction decoding process has successfully been performed, the delivery confirmation signal indicating that reception of the transmission data signal has been completed is generated for each unit of delivery confirmation and transmitted to the transmission-side communication apparatus. Thus, even if the present invention is applied to a communication system that has a possibility of experiencing such a state of communication line in which a re-transmission request is frequently made, an advantageous effect is achieved where it is possible to avoid or inhibit a temporary and drastic degradation of the user throughput.

BRIEF DESCRIPTION OF DRAWINGS

[Fig. 1] Fig. 1 is a diagram of a functional configuration of a communication system according to a first embodiment of the present invention.
[Fig. 2] Fig. 2 is a diagram for explaining a modification example of the first embodiment.
[Fig. 3] Fig. 3 is a diagram for explaining another modification example of the first embodiment that is different from the one shown in Fig. 2.
[Fig. 4] Fig. 4 is a diagram for explaining yet another modification example of the first embodiment that is different from the ones shown in Figs. 2 and 3.
[Fig. 5] Fig. 5 is a diagram for explaining yet another modification example of the first embodiment that is different from the ones shown in Figs. 2 to 4.
[Fig. 6] Fig. 6 is a diagram for explaining yet another modification example of the first embodiment that is different from the ones shown in Figs. 2 to 5.
[Fig. 7] Fig. 7 is a diagram for explaining yet another modification example of the first embodiment that is different from the ones shown in Figs. 2 to 6.

[Fig. 8] Fig. 8 is a diagram for explaining yet another modification example of the first embodiment that is different from the ones shown in Figs. 2 to 7.

[Fig. 9] Fig. 9 is a diagram of a functional configuration of a communication system according to a second embodiment of the present invention.

[Fig. 10] Fig. 10 is a diagram of a functional configuration of a communication system according to a third embodiment of the present invention.

[Fig. 11] Fig. 11 is a diagram of a functional configuration of a communication system according to a fourth embodiment of the present invention.

[Fig. 12] Fig. 12 is a drawing of communication connections that are made between communication stations included in a typical mobile communication system.

[Fig. 13] Fig. 13 is a table of contents defined in header information for concatenations.

[Fig. 14-1] Fig. 14-1 is a diagram of a bit structure of the header information for concatenations.

[Fig. 14-2] Fig. 14-2 is a diagram of an example of MAC_SDUs that constitute transmission data.

[Fig. 14-3] Fig. 14-3 is a schematic diagram of a frame structure of an RDT_SDU that is generated based on the MAC_SDUs shown in Fig. 14-2.

[Fig. 15] Fig. 15 is a drawing of a concept of a data flow in a transmission-side communication apparatus.

[Fig. 16] Fig. 16 is a table of contents defined in a fragmentation sub-header.

[Fig. 17] Fig. 17 is a table of contents defined in a packing sub-header.

[Fig. 18] Fig. 18 is a table of contents defined in an RDT sub-header.

[Fig. 19] Fig. 19 is a table of contents defined as a transmission condition for feedback information that is transmitted from a reception-side transmission apparatus to the transmission-side communication apparatus.

[Fig. 20] Fig. 20 is a table of detailed contents defined as the feedback information shown in Fig. 19.

[Fig. 21] Fig. 21 is a diagram of a communication flow used by the transmission-side communication apparatus when transmission control is exercised by using a timer.

[Fig. 22] Fig. 22 is a drawing of a concept of a data flow in a reception-side communication apparatus.

[Fig. 23] Fig. 23 is a diagram of a communication flow used by the reception-side communication apparatus when transmission control is exercised by using a timer.

[Fig. 24] Fig. 24 is a diagram of a user plane protocol stack in a communication system according to a sixth embodiment of the present invention.

[Fig. 25] Fig. 25 is a diagram of a ciphering process and a frame aggregation process during a transmission process performed by a BS, according to the sixth embodiment of the present invention.

EXPLANATIONS OF LETTERS OR NUMERALS

11, 12 TRANSMISSION-SIDE COMMUNICATION APPARATUS
21 RECEPTION-SIDE COMMUNICATION APPARATUS
31, 32 IP PACKETS
41, 43 TRANSMISSION DATA SIGNAL
42, 44 DELIVERY CONFIRMATION SIGNAL
51, 52 COMMUNICATION PATH
61 SUPERORDINATE APPARATUS
71, 72 CONTROL SIGNAL
80 FRAMES
81 HEADER PORTION
82 BODY PORTION
83 PHYSICAL LAYER CAPACITY
91 HANDOVER ORIGIN WIRELESS BASE STATION
92 HANDOVER DESTINATION WIRELESS BASE STATION
93 MOBILE COMMUNICATION TERMINAL
111 DATA STORING UNIT
112 ERASURE CORRECTION ENCODING UNIT
112a, 112b, 213a, 213b BUFFER
113 TRANSMISSION SCHEDULING UNIT
114, 215 ERROR CORRECTION ENCODING UNIT
115, 216 MODULATING UNIT

116, 211 DEMODULATING UNIT
117, 212 ERROR CORRECTION DECODING UNIT
213 ERASURE CORRECTION DECODING UNIT
214 IP PACKET REPRODUCING UNIT
301 BASE STATION (BS)
302 RELAY STATION (RS)
303 MOBILE TERMINAL (MS)
601 CONVERGENCE SUB-LAYER FOR BS
611 UPPER-MAC LAYER FOR BS
612 ARQ FUNCTION IN UPPER-MAC LAYER FOR BS
613 MAC_PDU GENERATING FUNCTION IN UPPER-MAC LAYER FOR BS
614 CIPHERING FUNCTION IN UPPER-MAC LAYER FOR BS
621 LOWER-MAC LAYER FOR BS
622 FRAME AGGREGATION FUNCTION IN LOWER-MAC LAYER FOR BS
623 RDT_with_ECC FUNCTION IN LOWER-MAC LAYER FOR BS
624 MAC_PDU GENERATING FUNCTION IN LOWER-MAC LAYER FOR BS
631 PHY LAYER FOR BS
641 BS-SIDE PHY LAYER FOR RS
651 MAC LAYER FOR RS
652 FRAME AGGREGATION FUNCTION IN MAC LAYER FOR RS
653 RDT_with_ECC FUNCTION IN MAC LAYER FOR RS
654 MAC_PDU GENERATING FUNCTION IN MAC LAYER FOR RS
661 BS-SIDE PHY LAYER FOR RS
671 PHY LAYER FOR MS
681 MAC LAYER FOR MS
682 ARQ FUNCTION IN MAC LAYER FOR MS
683 MAC_PDU GENERATING FUNCTION IN MAC LAYER FOR MS
684 CIPHERING FUNCTION IN MAC LAYER FOR MS
691 CONVERGENCE SUB-LAYER FOR MS

BEST MODE(S) FOR CARRYING OUT THE INVENTION

Exemplary embodiments to illustrate a communication system, a transmission-side communication apparatus, and a reception-side communication apparatus according to the present invention will be explained in detail with reference to the accompanying drawings. The present invention is not limited to these exemplary embodiments.

First Embodiment

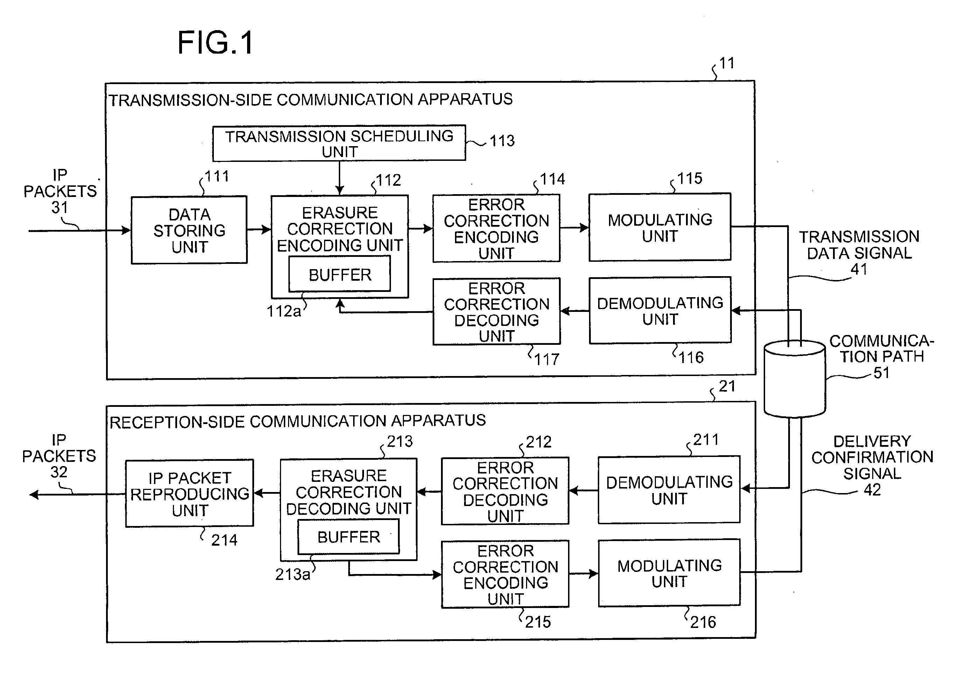

Fig. 1 is a diagram of a functional configuration of a communication system according to a first embodiment of the present invention. Shown in Fig. 1 is a configuration example according to the first embodiment in which an ARQ method is realized by using an erasure correction code (or an erasure correction Low Density Parity Check [LDPC] code).
In Fig. 1, the communication system includes a transmission-side communication apparatus 11 and a reception-side communication apparatus 21. The transmission-side communication apparatus 11 includes constituent elements such as a data storing unit 111, an erasure correction encoding unit 112, a transmission scheduling unit 113, an error correction encoding unit 114, and a modulating unit 115. Also, the transmission-side communication apparatus 11 includes, as the constituent elements that process feedback information from the reception-side communication apparatus 21, a demodulating unit 116 and an error correction decoding unit 117. The reception-side communication apparatus 21 includes constituent elements such as a demodulating unit 211, an error correction decoding unit 212, an erasure correction decoding unit 213, and an Internet Protocol (IP) packet reproducing unit 214. Also, the reception-side communication apparatus 21 includes, as the constituent elements that generate and output the feedback information to be transmitted to the transmission-side communication apparatus 11, an error correction encoding unit 215 and a modulating unit 216.
In the transmission-side communication apparatus 11, IP packets 31 are input to the data storing unit 111, and the IP packets 31 are output from the modulating unit 115. Also, a delivery confirmation signal (ACK) 42 that has been transmitted via a communication path 51 is input to the demodulating unit 116.
In the reception-side communication apparatus 21, a transmission data signal 41 that has been transmitted via the communication path 51 is input to the demodulating unit 211, and IP packets 32 are output from the IP packet reproducing unit 214 to, for example, an application or another communication apparatus (not shown). Also, the delivery confirmation signal (ACK) 42 is output from the modulating unit 216 of the reception-side communication apparatus 21.

In the explanation below, the example of the configuration as shown in Fig. 1 will be used in which the transmission-side communication apparatus 11 includes the error correction encoding unit 114 and the error correction decoding unit 117, while the reception-side communication apparatus 21 includes the error correction decoding unit 212 and the error correction encoding unit 215. However, in the case where the quality of the communication path 51 is good, or in the case where the modulation and the demodulation processes are performed based on a modulation method having a high level or error tolerance (including the reputation method), it is acceptable to omit these constituent elements.

In the configuration shown in Fig. 1, the example is shown in which the IP packets are input to the transmission-side communication apparatus and output from the reception-side communication apparatus 21. However, the input signal and the output signal are not limited to the IP packets. Further, depending on the system configuration and the communication method being used, it is acceptable to omit some of the constituent elements such as, for example, the data storing unit 111 included in the transmission-side communication apparatus 11 and the IP packet reproducing unit 214 included in the reception-side communication apparatus 21.

Also, in the configuration shown in Fig. 1, the example is shown in which the transmission-side communication apparatus 11 and the reception-side communication apparatus 21 are in a one-to-one correspondence. However, another arrangement is acceptable in which a plurality of reception-side communication apparatuses 21 are used so that the transmission-side communication apparatus 11 and the reception-side communication apparatuses 21 are in a one-to-N correspondence.

Next, an operation of the communication system according to the first embodiment will be explained with reference to Fig. 1. In Fig. 1, the IP packets 31 to be delivered to the reception-side communication apparatus 21 are input to the transmission-side communication apparatus 11. The data storing unit 111 stores therein the input IP packets 31 until the data amount reaches a predetermined level of data amount or until a predetermined period of time has elapsed since the start of the process to store the IP packets 31. The process to store the IP packets 31 explained above and any other processes explained below are performed for each connection (i.e., for each user), unless stated otherwise.

"The predetermined level of data amount" mentioned above denotes, for example, a data amount expressed with a value obtained by subtracting the data amount of header information (e.g., padding size information) from the value of $K \times Lmax$, where K is the number of information packets before an erasure correction encoding process is performed, and Lmax is the maximum length of the information packet.

In the process described above, in the case where the process to store the IP packets into the data storing unit 111 is performed based on "the predetermined level of data amount", the data storing unit 111 forwards, for example, the data that has been stored therein and the header information to the erasure correction encoding unit 112 after dividing the data and the header information into as many information packets as K, while each of the information packets has a length of $L = Lmax$.

In the case where the IP packets that have been stored in the data storing unit 111 has not reached "the predetermined level of data amount", the process to store the IP packets is performed until "the predetermined period of time has elapsed". In this situation, the data storing unit 111 forwards the stored data to the erasure correction encoding unit 112 after dividing the data into as many information packets as K, while each of the information packets has a length of L and is padded so as to have a size of KxL, where the length L is determined so that the sum P of the data amount of the stored data and the amount of the header information satisfies $P < K \times L$.

The erasure correction encoding unit 112 stores the group of information packets (hereinafter, "information packet group") that has been received from the data storing unit 111 into a buffer 112a included therein. The transmission scheduling unit 113 determines a modulation method for each user based on the information such as a Carrior to Noise Ratio (CRN) and a Bit Error Rate (BER) for the connection. The transmission scheduling unit 113 also calculates a transmission amount for each connection. In addition, the erasure correction encoding unit 112 generates, based on an erasure correction code, a number of coded packets that fits within the range of the transmission amount determined and instructed by the transmission scheduling unit 113 and forwards the generated coded packets to the error correction encoding unit 114. In this situation, a packet header containing sequence numbers showing the order of packet generation and the length L of the packets is appended to the generated erasure correction coded packets. Further, a Cyclic Redundancy Check (CRC) code that is used on the reception side to judge whether the packet has successfully been received or not is also appended to the generated erasure correction coded packets. The size of the packet header can be can be reduced if, inn this situation, for example, a piece of one-bit information is used for judging whether the packet length L is Lmax or not, and the length L is not appended when L=Lmax is satisfied. Also, it is preferable to have an arrangement in which the sequence numbers are reset for each information packet group forwarded from the data storing unit 111.

The error correction encoding unit 114 forwards the erasure correction coded packets that have been received from the erasure correction encoding unit 112 to the modulating unit 115, after performing an error correction encoding process thereon. The modulating unit 115 performs a digital modulation process according to a modulation method such as Binary Phase Shift Keying (BPSK), Quadrature Phase Shift Keying (QPSK), or multi-value Quadrature Amplitude Modulation (QAM). The modulating unit 115 then transmits a generated modulation signal as the transmission data signal 41 to the reception-side communication apparatus 21 via the communication path 51.

The transmission data signal 41 transmitted from the transmission-side communication apparatus 11 is input to the reception-side communication apparatus 21. The demodulating unit 211 performs a digital demodulation process on the transmission data signal 41, based on the modulation method that has been applied to the transmission data signal 41 (e.g., a BPSK, a QPSK, or a multi-value QAM), and forwards the demodulated data to the error correction decoding unit 212. The error correction decoding unit 212 receives the demodulated data from the demodulating unit 211 and performs an error correction decoding process thereon. The error correction decoding unit 212 then forwards the result to the erasure correction decoding unit 213.

The erasure correction decoding unit 213 judges whether the received packets have properly been received, based on the CRC code. In the case where the received packets have properly been received, the erasure correction decoding unit 213 stores the received packets that have been input thereto, into a buffer 213a in the order indicated by the sequence numbers. When the number of received packets becomes equal to or larger than the number of information packets specified on the transmission side (specified as K in the first embodiment), the erasure correction decoding unit 213 performs an erasure correction decoding process by using all of the received packets stored in the buffer 213a. Further, in the case where the erasure correction decoding process has successfully been performed, the erasure correction decoding unit 213 clears all of the received packets from the buffer 213a and sequentially forwards the information packet group that has been decoded, to the IP packet reproducing unit 214. Further, the erasure correction decoding unit 213 generates a reception completion signal (ACK). The error correction encoding unit 215 performs an error correction encoding process thereon. Subsequently, the modulating unit 216 performs a digital modulation process based on the predetermined modulation method, so that the modulation signal is transmitted as a delivery confirmation signal (ACK) 42 to the transmission side via the communication path 51. On the other hand, in the case where the erasure correction decoding process has failed, the erasure correction decoding unit 213 continues to receive the received packets until the decoding process is successfully performed.

The IP packet reproducing unit 214 connects together the information packet group that has been received from the erasure correction decoding unit 213 and extracts IP packets by referring to the information such as the header information (e.g., the padding size information) and the length information of the IP packets. The IP packet reproducing unit 214 then performs a process of, for example, forwarding the extracted packets to an application layer or transferring the extracted packets to another communication apparatus, as the IP packets 32. In the case where the information that is required in the generation of the IP packets is partially contained in both the present information packet group and the next information packet group, the data that is received first is stored so that, after the next information packet group has been received, the packets are connected together so as to reproduce the desired IP packets.

The delivery confirmation signal 42 that has been transmitted from the reception-side communication apparatus 21 is returned to the transmission-side communication apparatus 11. The demodulating unit 116 forwards the returned delivery confirmation signal 42 to the error correction decoding unit 117, after performing a digital demodulation process thereon. Having received the demodulated data from the demodulating unit 116, the error correction decoding unit 117 performs an error correction decoding process thereon and forwards the result to the erasure correction encoding unit 112. Having received the delivery confirmation signal, the erasure correction encoding unit 112 clears the buffer of the information packet group on which an encoding process is currently being performed and sets the next information packet group that has been received from the data storing unit 111 as the target of an encoding process. Thus, until the transmission-side communication apparatus 11 receives the delivery confirmation signal, the transmission-side communication apparatus 11 assumes that the information that is currently being transmitted has not been completely received by the reception-side communication apparatus 21 and continues to generate and transmit redundancy packets (i.e., erasure correction coded packets) to the reception-side communication apparatus 21.

As explained above, the transmission-side communication apparatus 11 generates new erasure correction coded packets while incrementing the sequence numbers, until the transmission-side communication apparatus 11 receives the delivery confirmation signal. However, it is not preferable to continue to generate the erasure correction coded packets in a limitless manner. Thus, for example, an arrangement is desirable in which a threshold value (i.e., an upper limit value) is specified based on a temporal aspect or a quantitative aspect, so that when the judgment element has reached the threshold value, the delivery confirmation process is discontinued and the transmission buffer is cleared, and also, the transmission is resumed with a next information packet group.

Also, it is a good idea to have an arrangement in which, in the case where the reception-side communication apparatus 21 has received an erasure correction coded packet from the transmission communication apparatus 11 after having transmitted a delivery confirmation signal 42 to the transmission-side communication apparatus 11, and if, for example, a large sequence number is being used, the reception-side communication apparatus 21 may discard the received packets and periodically notify the transmission-side communication apparatus 11 with a delivery confirmation signal. It is also a good idea to have another arrangement in which, when a predetermine period of time has elapsed after the delivery confirmation signal 42 is transmitted, the reception-side communication apparatus 21 may discard the received erasure correction coded packets and notify the transmission-side communication apparatus 11 with a delivery confirmation signal every time the erasure correction coded packets have been received. After that, it is also a good idea to have an arrangement in which, when erasure correction coded packets of which the sequence numbers have gone back to smaller numerical values have been received, the reception-side communication apparatus 21, recognizing that the transmission of the next information packet group has been started, starts storing the received packets into the buffer and stops notifying the transmission-side communication apparatus 11 with the delivery confirmation signal.

As explained above, in the communication system according to the first embodiment, it is understood on the transmission side that when no delivery confirmation signal is received, it implicitly means that re-transmission is requested so that the redundancy packets continue to be transmitted to the reception side. With this arrangement, even if a delivery confirmation is made for each information packet group, it is possible to reduce, by a large amount, the feedback information to be transmitted to the transmission side without degrading the user throughput significantly.

Also, in the communication system according to the first embodiment, it is not necessary to have the functions of a window controlling unit and a state management unit that are required when, for example, the SR_ARQ method is used. Thus, it is possible to simplify the control and make the scale of the circuit smaller.

In addition, because the communication system according to the first embodiment has no restriction related to full duplex or half duplex, it is possible to apply the communication system to any communication method.

It is possible to modify a part of the first embodiment as described below, from the following aspects:

(1) the size of the packet headers;
(2) the delay amount related to the storing of the data;
(3) compatibility with a plurality of modulation methods (i.e., adaptive modulation control); and
(4) the throughput related to the delivery confirmation.

First Embodiment - First Modification Example

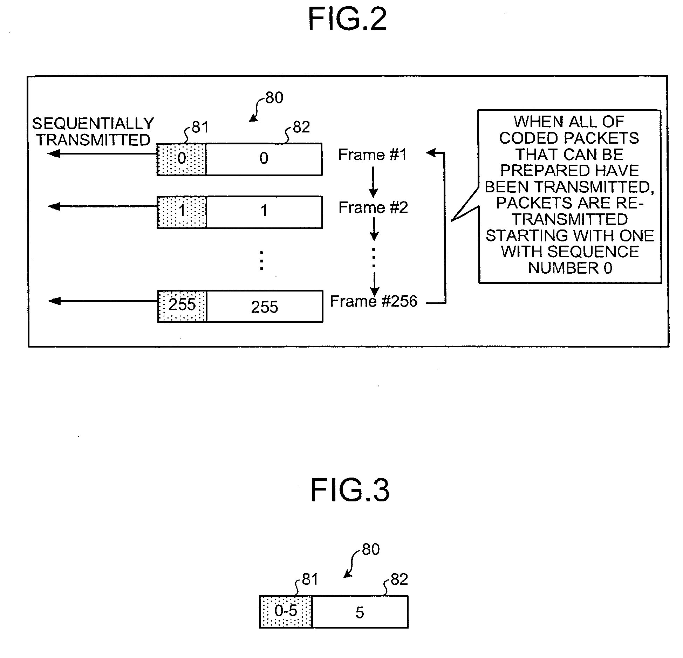

Fig. 2 is a diagram for explaining a modification example of the first embodiment. Shown in Fig. 2 is one technique for inhibiting an increase in the size of the packet header. In the example shown in Fig. 2, 256 frames (i.e., Frames #1 through #256) 80 that each contain an erasure correction coded packet as their data are prepared and transmitted sequentially. In this example, each of the frames 80 is made up of a header portion 81 and a body portion 82. Information of a sequence number (a serial number assigned to the body portion 82) used for identifying the frame (i.e., the erasure correction coded packet) is stored in the header portion 81.

As shown in Fig. 2, in the case where the upper limit value for the number of erasure correction coded packets that can be prepared is set to a relatively small value, and all the frames that are prepared in advance have been transmitted, the frames are retransmitted from the sequence number of the erasure correction coded packet that was transmitted first. For example, in the case where the upper limit value of the sequence number is set to 255, it is sufficient if the area in the packet header used for indicating the sequence number has 8 bits at most. Thus, it is possible to inhibit an increase in the size of the header. In the re-transmission process as described above, a group of frames starting with the initial value of the sequence number and ending with the upper limit value of the sequence number (hereinafter "a transmission block") is used as one unit, so that a delivery confirmation is made for each transmission block. In consideration of situations where no delivery confirmation arrives from the reception-side communication apparatus 21, an arrangement is acceptable in which, for example, an upper limit value is set also for the number of transmission frames that are transmitted from the transmission-side communication apparatus so that the delivery confirmation process is discontinued based on the upper limit value.

First Embodiment - Second Modification Example

Fig. 3 is a diagram for explaining another modification example of the first embodiment that is different from the one shown in Fig. 2. More specifically, shown in Fig. 3 is one technique for identifying, without fail, the information packet group received by the reception-side communication apparatus. In Fig. 3, in addition to the information of the sequence number shown in Fig. 2 (i.e., "5" as in "0-5" indicated in the example shown in Fig. 3), the sequence number of the information packet group (i.e., "0" as in "0-5" indicated in the example shown in Fig. 3) is added to the header portion 81 of each of the frames 80. When the information that indicates the sequence number of the information packet group is added to the header portion 81 of each of the frames 80 like in this example, it is possible to understand, without fail, whether the erasure correction coded packet that is currently received by the reception-side communication apparatus 21 is one that is generated from a new information packet group. Also, by limiting the sequence numbers used for the information packet groups to two (i.e., "0" and "1"), a one-bit area will be sufficient. Thus, it is possible to inhibit an increase in the size of the header.

First Embodiment - Third Modification Example

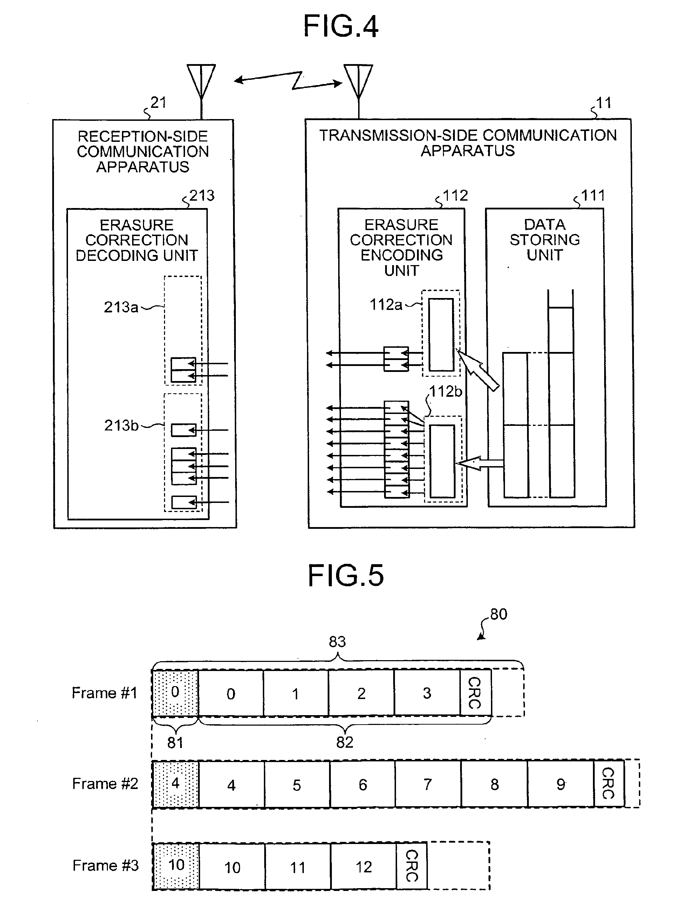

Fig. 4 is a diagram for explaining yet another modification example of the first embodiment that is different from the ones shown in Figs. 2 and 3. Shown in Fig. 4 is one technique for inhibiting degradation of the user throughput that is caused during a delivery confirmation process. In Fig. 4, the erasure correction encoding unit 112 in the transmission-side communication apparatus 11 includes two transmission buffers 112a and 112b. Similarly, the erasure correction decoding unit 213 in the reception-side communication apparatus 21 includes two reception buffers 213a and 213b. The number of buffers is not limited to two. Another arrangement is acceptable where three or more buffers are included in each of these units.

In the example shown in Fig. 3 where the sequence numbers are assigned to the information packet groups, there will be a transmission wait period until the transmission buffer and the reception buffer are cleared. However, in the example shown in Fig. 4 where two or more transmission buffers and two or more reception buffers are included, after the erasure correction coded packets corresponding to an information packet group have been transmitted a predetermined number of times, it is possible to transmit the erasure correction coded packets corresponding to a next information packet group as well, in a mixed manner, even if a delivery confirmation signal has not yet been received from the reception-side communication apparatus 21. Thus, it is possible to inhibit degradation of the user throughput that is caused during the delivery confirmation process.

First Embodiment - Fourth Modification Example

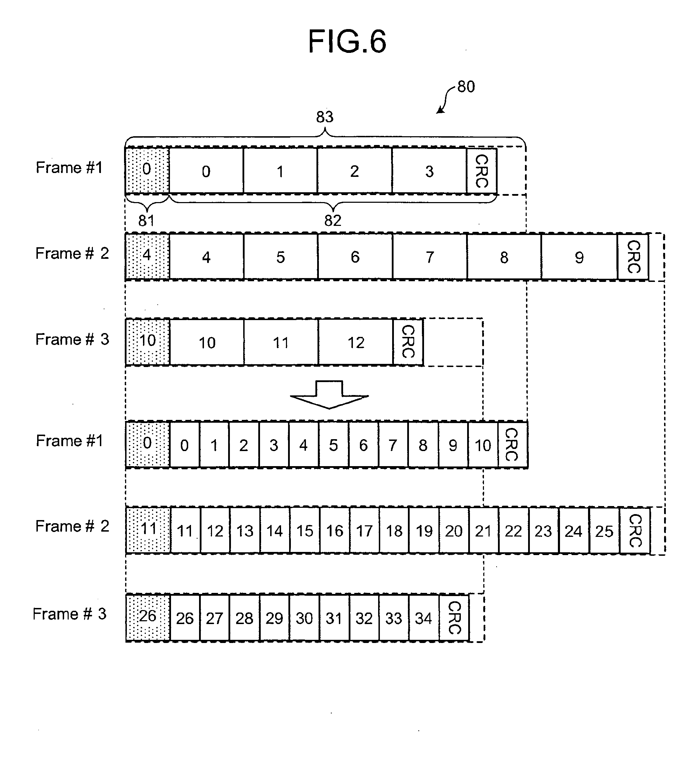

Figs. 5 and 6 are diagrams for explaining other modification examples of the first embodiment that are different from the ones shown in Figs. 2 to 4. Shown in Figs. 5 and 6 are techniques for effectively inhibiting degradation of the user throughput that is caused during a delivery confirmation process, while inhibiting an increase in the size of the packet header. In Fig. 5, areas that are shown with bold broken lines and each surround one of the frames 80 each indicate a physical layer capacity 83. Generally speaking, a physical layer capacity that is assigned at a point in time varies for each period of time or for each user. Thus, shown in Fig. 5 is how the physical layer capacities are different from one another.

Let us discuss a situation in which the erasure correction encoding unit 112 included in the transmission-side communication apparatus 11 forwards erasure correction coded packets to the error correction encoding unit 114. In this situation, the erasure correction encoding unit 112 packs the erasure correction coded packets according to the physical layer capacity 83. On the other hand, since the packet length of each of the erasure correction coded packets that constitute the frame 80 is predetermined, it is possible to reduce the header size by, when packing the packets, putting only the sequence number of the erasure correction coded packet positioned at the head into the packet header, as shown in Fig. 5.

When the packing technique as described above is used, it is possible to increase the effect of reducing the header size because only one CRC code needs to be appended to the packing data. Additionally, when the packing technique described above is used, by putting the information of the packet length of the erasure correction coded packets into, for example, the header portion 81, it is possible to deliver this information to the destination of the communication. Also, as shown in the lower half of Fig. 6, by making the packet size smaller for the erasure correction coded packets that structure each of the frames 80, it is possible to improve the utilization efficiency of each physical layer capacity 83 that has been assigned. Consequently, it is also possible to improve the user throughput.

First Embodiment - Fifth modification example

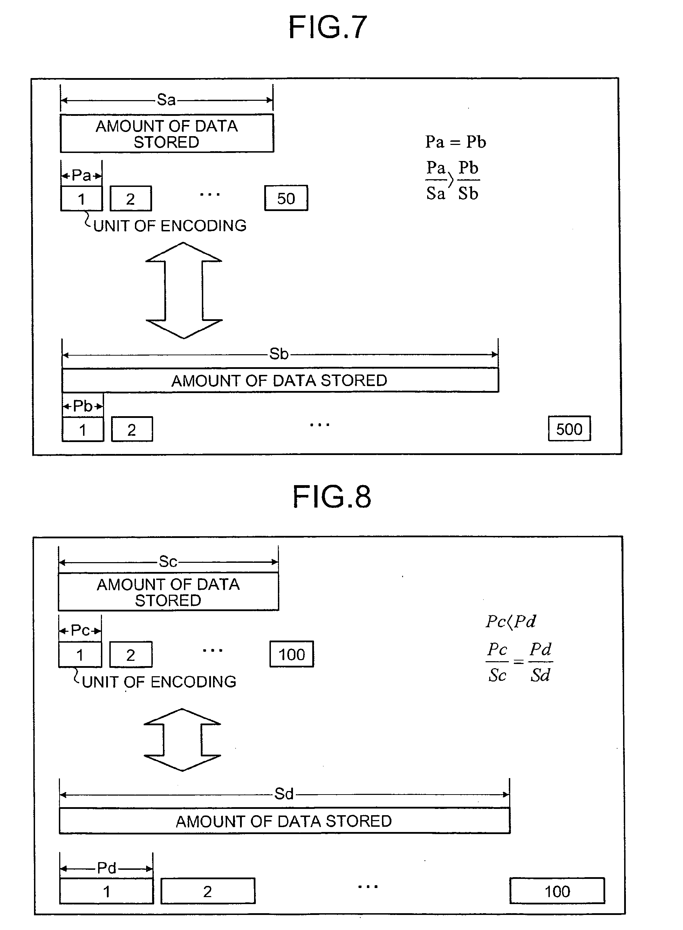

Figs. 7 and 8 are drawings for explaining other modification examples of the first embodiment that are different from the ones shown in Figs. 2 to 6. Shown in Figs. 7 and 8 are techniques for adjusting a transmission delay amount related to the storing of the data. For example, as shown in Fig. 7, it is possible to adjust the delay amount related to the storing of the data by having an arrangement in which the encoding process is performed on the erasure correction coded packets in units that are constant ($Pa=Pb$), while the number of packets being packed when the erasure correction coded packets are generated is a variable value ($50 \rightarrow 500$). Also, as shown in Fig. 8, it is also possible to adjust the delay amount related to the storing of the data by having another arrangement in which the number of packets being packed when the erasure correction coded packets are generated is constant (i.e., 100), while the encoding process is performed on the erasure correction coded packets in units that are variable ($pc \rightarrow Pd : Pc < Pd$). When this type of control is exercised on the delay amount related to the storing of the data according to the Quality of Service (QoS) class, it is also possible to flexibly apply the technique to a communication system in which data communication and audio communication are mixed together.

As explained above, in consideration of occurrence of transmission delay related to the storing of the data, it is possible to adjust the delay amount related to the storing of the data by increasing or decreasing, according to the QoS class, the number of erasure correction coded packets corresponding to the coding rate of "1", without having to change the packet size of each of the erasure correction coded packets. Also, it is possible to adjust the delay amount related to the storing of the data by increasing or decreasing, according to the QoS class, the packet size of each of the erasure correction coded packets, without having to change the number of erasure correction coded packets corresponding to the coding rate of "1".

First Embodiment - Sixth Modification Example

According to the first embodiment, as explained above, the instructions related to the modulation method for each user and the transmission amount for each connection are output from the transmission scheduling unit 113 to the erasure correction encoding unit 112. In this situation, it is possible to easily perform the scheduling in such a manner that, for example, as many erasure correction coded packets as X at the beginning are assigned to the modulation method called 64 QAM, whereas as many erasure correction coded packets as Y that follow are assigned to the modulation method called 16 QAM, and erasure correction coded packets that further follow are assigned to the modulation method called QPSK. In other words, it is possible to easily perform the scheduling so as to lower the degree of modulation and raise the degree of redundancy on the assumption that the larger the number of packets being transmitted is, the lower the quality of communication becomes. Thus, it is possible to simplify the functions of the adaptive modulation control. Also, in some situations, it is possible to omit the functions of the adaptive modulation control themselves.

As described above, according to the present embodiment, in the transmission-side communication apparatus, the erasure correction encoding process is performed on the information packet group that is made up of the plurality of packets to be transmitted, so that the one or more erasure correction coded packets that fit the predetermined transmission amount are generated. The one or more erasure correction coded packets are specified as one of units in which a delivery confirmation is made (hereinafter "a unit of delivery confirmation") and are transmitted to the reception-side communication apparatus. In the reception-side communication apparatus, the information packet group is generated by performing the erasure correction decoding process on the received signal. In the case where the erasure correction decoding process has successfully been performed, the delivery confirmation signal indicating that reception of the transmission data signal has been completed is generated for each unit of delivery confirmation and transmitted to the transmission-side communication apparatus. Thus, even if the present invention is applied to a communication system that has a possibility of experiencing such a state of communication line in which a re-transmission request is frequently made, an advantageous effect is achieved where it is possible to avoid or inhibit a temporary and drastic degradation of the user throughput.

Also, when the techniques according to the first embodiment are used, the re-transmission process performed by the transmission-side communication apparatus is equivalently substituted by an additional transmission of the erasure correction coded packets. As a result, the frequency with which the delivery confirmation signals are transmitted to the feedback channel and the frequency with which the ARQ transmission window is updated are significantly lowered. Thus, for these reasons also, it is possible to avoid or inhibit temporal and drastic degradation of the user throughput.

In addition, it is possible to avoid degradation of the user throughput more effectively by arranging the size of the unit of delivery confirmation to be large compared to the packet size of each of the erasure correction coded packets, or by arranging the packet size of each of the erasure correction coded packets to be sufficiently small compared to the size of the unit of delivery confirmation.

Second Embodiment

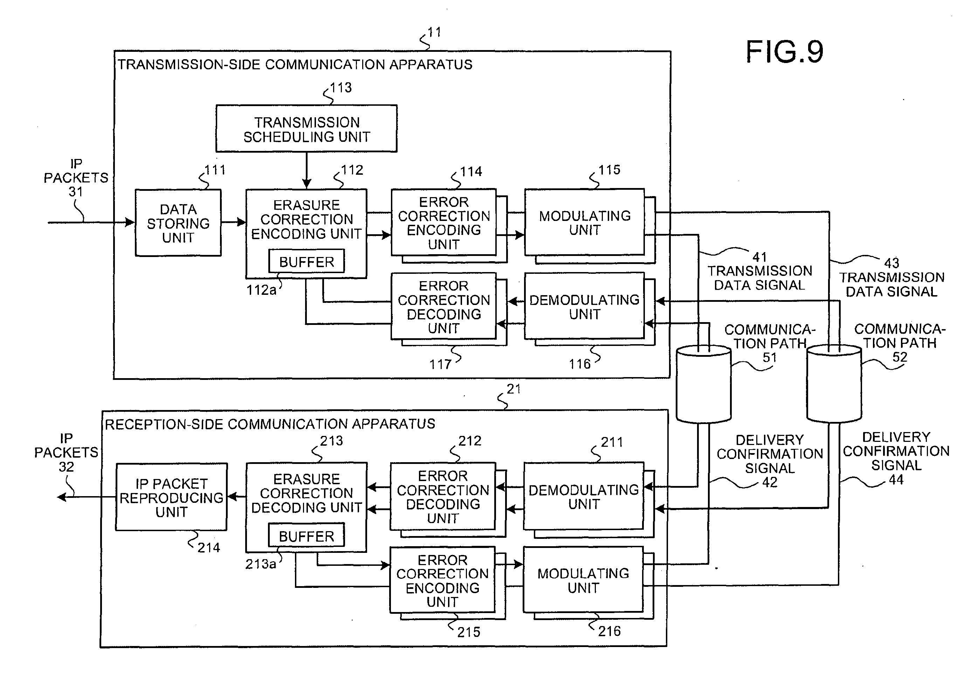

Fig. 9 is a diagram of a functional configuration of a communication system according to a second embodiment of the present invention. In Fig. 9, the basic configuration of the transmission-side communication apparatus 11 is the same as that according to the first embodiment; however, the constituent elements such as the error correction encoding unit 114, the modulating unit 115, the demodulating unit 116, and the error correction decoding unit 117 contain a plurality of channels that use mutually the same communication access method or a plurality of communication access methods. In some situations, another arrangement is acceptable in which the constituent elements such as the error correction encoding unit 114 and the error correction decoding unit 117 are shared between the plurality of channels or between the plurality of communication access methods.

Similarly, the basic configuration of the reception-side communication apparatus 21 is the same as that according to the first embodiment; however, the constituent elements such as the demodulating unit 211, the error correction decoding unit 212, the error correction encoding unit 215, and the modulating unit 216 are able to perform communication based on a plurality of channels that use mutually the same communication access method, a plurality of communication access methods, or a combination thereof. In some situations, another arrangement is acceptable in which the constituent elements such as the error correction decoding unit 212 and the error correction encoding unit 215 are shared between the plurality of channels or between the plurality of communication access methods.

In Fig. 9, an example is shown in which two channels or two communication access methods are contained. In this configuration, the transmission-side communication apparatus 11 transmits transmission data signals 41 and 43 generated based on the IP packets 31 that have been input thereto, to the reception-side communication apparatus 21 via communication paths 51 and 52, respectively. The present invention is not limited to the example in which two channels and/or two communication access methods are used. Another arrangement is acceptable in which three or more channels and/or communication access methods are contained.

The number of constituent elements such as the demodulating unit 116 and the error correction decoding unit 117 that are included in the transmission-side communication apparatus 11 and that process delivery confirmation signals 42 and 44 as well as the error correction encoding unit 215 and the modulating unit 216 that are included in the reception-side communication apparatus 21 and that generate the delivery confirmation signals 42 and 44 does not necessarily have to be equal to the number of constituent elements such as the error correction encoding unit 114 and the modulating unit 115 that are included in the transmission-side communication apparatus 11. Another arrangement is acceptable in which only one constituent elements or a smaller number of constituent elements are included.

Next, an operation of the communication system according to the second embodiment will be explained, with reference to Fig. 9. The basic flow of the processes is the same as the one according to the first embodiment. Thus, only the part that is different from the first embodiment will be mainly explained.

First, like in the operation according to the first embodiment, in the transmission-side communication apparatus 11, the erasure correction encoding unit 112 receives an information packet group from the data storing unit 111 and stores the received information packet group into the buffer 112a. Subsequently, the transmission scheduling unit 113 determines a transmittable amount for each channel or each communication access method. The erasure correction encoding unit 112 generates, based on an erasure correction code, a number of packets that fit the transmission amount corresponding to each channel or each communication access method as instructed by the transmission scheduling unit 113. The erasure correction encoding unit 112 then forwards the generated packets to the error correction encoding unit 114. In this situation, as for the sequence numbers assigned to the erasure correction coded packets, it is preferable to have an arrangement in which, for example, the sequence numbers are used in common between the plurality of channels or the plurality of communication access methods, instead of assigning independent sets of sequence numbers respectively, so that mutually different sets of erasure correction coded packets are transmitted for mutually the same information packet group to be encoded even between the plurality of channels or the plurality of communication access methods.

In the reception-side communication apparatus 21, when having properly received the erasure correction coded packets, the erasure correction decoding unit 213 stores the received packets that have been input thereto, into the buffer 213a according to the order indicated by the sequence numbers, without being concerned that the channels are mutually different or that the communication access methods are mutually different and performs an erasure correction decoding process. When having successfully performed the erasure correction decoding process, the erasure correction decoding unit 213 forwards the decoded information packet group to the IP packet reproducing unit 214 and also gives information that is required in the generation of the delivery confirmation signals 42 and 44 to the error correction encoding unit 215. The error correction encoding unit 215 performs an error correction encoding process is output from the modulating unit 216 through a communication access method or a channel having good communication line quality or through a fixed communication access method or a fixed channel. The processes that are performed thereafter are the same as those according to the first embodiment. Thus, the explanation thereof will not be repeated.

As explained above, in the communication system according to the second embodiment, the erasure correction coded packets are transmitted while being distributed in the plurality of channels or the plurality of communication access methods. After that, when the erasure correction decoding process is performed in the reception-side communication apparatus, the distributed erasure correction coded packets are put together. Thus, it is possible to achieve a diversity effect between the mutually different channels or the mutually different communication access methods. In addition, even if such a method is used, the reception-side communication apparatus is able to process the data without being concerned that the channels are mutually different or that the communication access methods are mutually different. Thus, it is possible to achieve the advantageous effect of preventing or inhibiting an increase in the delay caused by a transmission delay difference between the channels or the communication access methods and preventing or inhibiting the degradation of the user throughput. In addition, it is possible to achieve an advantageous effect where the reception-side communication apparatus does not need to control the order of the received packets.

Third Embodiment

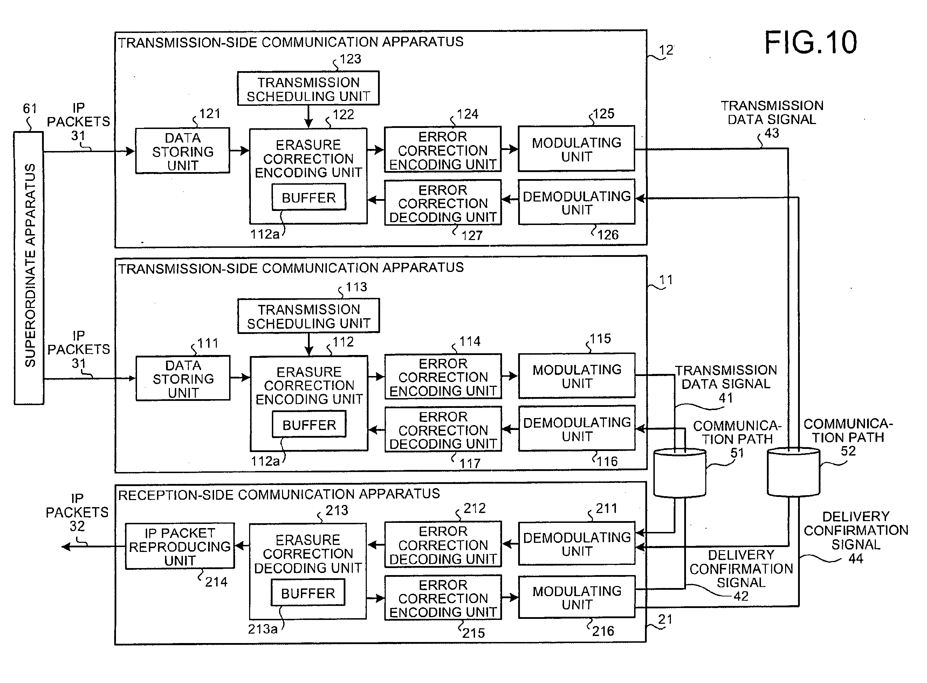

Fig. 10 is a diagram of a functional configuration of a communication system according to a third embodiment of the present invention. The basic configuration of the communication system shown in Fig. 10 is the same as the one according to the second embodiment shown in Fig. 9; however, the communication system is configured so as to include two transmission-side communication apparatuses. More specifically, provided on the transmission side are two communication apparatuses such as the transmission-side communication apparatus 11 and a transmission-side communication apparatus 12 that are connected to a superordinate apparatus 61. The outputs of these transmission-side communication apparatuses are transmitted to a single reception-side communication apparatus, i.e., the reception-side communication apparatus 21, via the communication path 51 and the communication path 52, respectively. The rest of the configuration is the same as or similar to the configuration according to the second embodiment. Thus, the same or similar constituent elements are referred to by using the same reference characters.

The configuration shown in Fig. 10 is a configuration example in which the transmission-side communication apparatuses and the reception-side communication apparatus are in a two-to-one correspondence. However, another arrangement is acceptable in which as many transmission-side communication apparatuses as N are used (where N is an integer that is equal to or larger than 3) so that the transmission-side communication apparatuses and the reception-side communication apparatus are in an N-to-1 correspondence. Further, yet another arrangement is acceptable in which as many reception-side communication apparatuses as M are used (where M is an integer that is equal to or larger than 2) so that the transmission-side communication apparatuses and the reception-side communication apparatuses are in an N-to-M correspondence.

Furthermore, the transmission-side communication apparatus 11 and the transmission-side communication apparatus 12 may use mutually the same communication system or mutually different communication systems. However, in the case where they use mutually different communication systems, it is also necessary to configure the reception-side communication apparatus 21 so as to include the demodulating unit 211, the error correction decoding unit 212, the error correction encoding unit 215, and the modulating unit 216 that are compatible with both of the mutually different communication systems.

Next, an operation of the communication system according to the third embodiment will be explained. The basic flow of the processes is the same as the one according to the first embodiment. Thus, only the part that is different from the first embodiment will be mainly explained.

In Fig. 10, the transmission-side communication apparatuses 11 and 12 receive, from the superordinate apparatus 61, the same set of IP packets 31 to be delivered to the reception-side communication apparatus and, like in the first embodiment, store therein the IP packets. In this situation, the superordinate apparatus 61 and the transmission-side communication apparatuses 11 and 12 exchange predetermined control information or exercise required ARQ control between themselves, as necessary, so that there is no discrepancy with regard to the number of received IP packets and the order in which the IP packets are received between the transmission-side communication apparatus 11 and the transmission-side communication apparatus 12.

Subsequently, the erasure correction encoding unit 112 included in the transmission-side communication apparatus 11 and the erasure correction encoding unit 112 included in the transmission-side communication apparatus 12 perform the encoding process after changing the starting number of the sequence numbers assigned to the erasure correction coded packets so that the sequence numbers do not overlap between these transmission-side communication apparatuses. The operation that is performed thereafter is the same as the one according to the first embodiment. The transmission data signals 41 and 43 that are generated in the transmission-side communication apparatus 11 and 12, respectively, are transmitted to the reception-side communication apparatus via the communication path 51 and 52, respectively.

In the reception-side communication apparatus 21, when having properly received the erasure correction coded packets, the erasure correction decoding unit 213 stores the received packets that have been input thereto, into the buffer 213a in the order indicated by the sequence numbers, without being concerned that the packets have been transmitted from the mutually different transmission-side communication apparatuses. The erasure correction decoding unit 213 then performs an erasure correction decoding process. When having successfully performed the erasure correction decoding process, the erasure correction decoding unit 213 forwards the decoded information packet group to the IP packet reproducing unit 214 and also gives information that is required in the generation of the delivery confirmation signals 42 and 44 to the error correction encoding unit 215. The error correction encoding unit 215 performs an error correction encoding process on the information, before the information is transmitted to both the transmission-side communication apparatus 11 and the transmission-side communication apparatus 12. The processes that are performed thereafter are the same as those according to the first embodiment. Thus, the explanation thereof will not be repeated.

As explained above, in the communication system according to the third embodiment, the erasure correction coded packets are transmitted while being distributed in the plurality communication apparatuses. After that, when the erasure correction decoding process is performed in the reception-side communication apparatus, the distributed erasure correction coded packets are put together. Thus, it is possible to achieve a diversity effect between the mutually different transmission-side communication apparatuses.

Fourth Embodiment

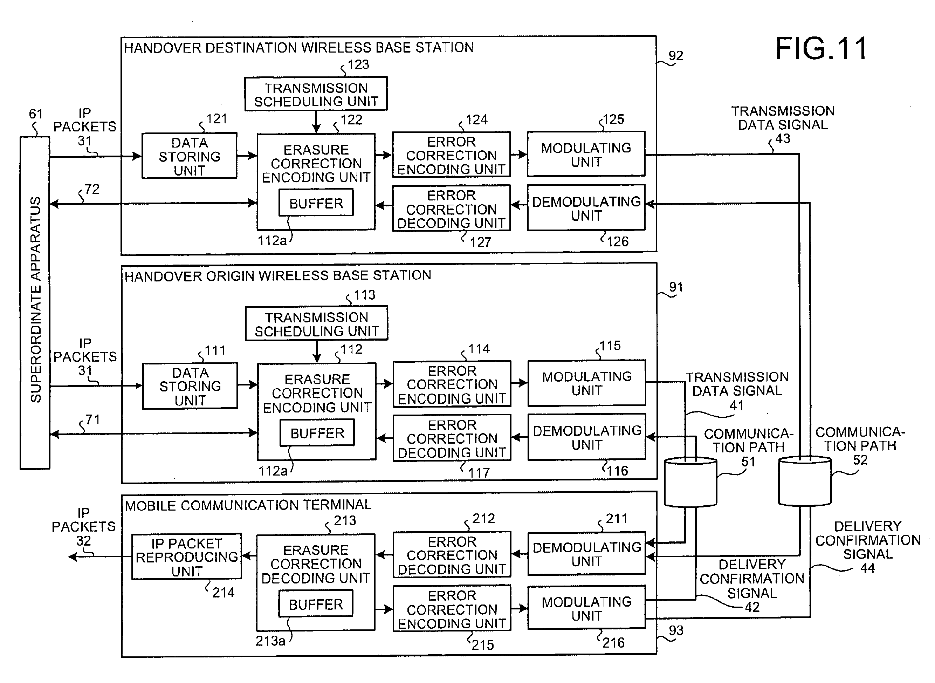

Fig. 11 is a diagram of a functional configuration of a communication system according to a fourth embodiment of the present invention. The communication system shown in Fig. 11 is obtained by configuring the communication system according to the third embodiment shown in Fig. 10 so that the transmission-side communication apparatus 11 functions as a handover origin wireless base station 91, while the transmission-side communication apparatus 12 functions as a handover destination wireless base station 92, and the reception-side communication apparatus 21 functions as a mobile communication terminal 93. The basic configuration and the functions thereof are the same as or similar to those according to the third embodiment. The same or similar constituent elements are referred to by using the same reference characters.

Next, an operation of the communication system according to the fourth embodiment will be explained. The basic flow of the processes is the same as the one according to the first embodiment. Thus, only the part that is different from the first embodiment will be mainly explained.

Let us assume that the mobile communication terminal 93 is currently performing predetermined wireless communication with the handover origin wireless base station 91, based on the functions described above. In this situation, when the mobile communication terminal 93 approaches the communication area of the handover destination wireless base station 92, the superordinate apparatus 61 recognizes this situation and continues to transmit the IP packets 31 to be delivered to the mobile communication terminal 93 to the handover origin wireless base station 91, and also starts transmitting the IP packets 31 to the handover destination wireless base station 92. At this time, to ensure that the handover origin wireless base station 91 is synchronized with the handover destination wireless base station 92, the superordinate apparatus 61 transmits a control signal 71 indicating a start of the synchronization to the handover origin wireless base station 91. Having received the control signal indicating the start of the synchronization, the handover origin wireless base station 91 performs an erasure correction encoding process on the data that had been stored therein before the point in time at which the control signal 71 was received, in the same manner as in the first embodiment where the process is performed until a predetermined period of time has elapsed after the start of the storing of the data. The handover origin wireless base station 91 thus completes the transmission.

Having started to receive the IP packets 31 to be delivered to the mobile communication terminal 93, the handover destination wireless base station 92 receives, from the superordinate apparatus 61, a control signal 72 indicating a start of the transmission and starts transmitting erasure correction coded packets to the mobile communication terminal 93. In this situation, by having an arrangement in which the starting number of the sequence numbers assigned to the erasure correction coded packets is different from the starting number for the handover origin wireless base station 91, it is possible to perform the encoding process in such a manner that the sequence numbers do not overlap between these wireless base stations.

The mobile communication terminal 93 receives the erasure correction coded packets from both the handover origin wireless base station 91 and the handover destination wireless base station 92, performs an erasure correction decoding process, and also puts the received sets of packets together. When a decoding process has successfully been performed, the mobile communication terminal 93 generates the delivery confirmation signals 42 and 44 and transmits the generated delivery confirmation signals 42 and 44 to the handover origin wireless base station 91 and the handover destination wireless base station 92, respectively.

In the case where, after communicating with both of the wireless base stations at the same time as described above, the mobile communication terminal 93 moves to the communication area of the handover destination wireless base station 92, the superordinate apparatus 61 transmits the control signal 71 indicating a stop of the transmission to the handover origin wireless base station 91. Based on the received control signal 71, the handover origin wireless base station 91 stops transmitting the erasure correction coded packets to the mobile communication terminal 93 and clears the buffer of the stored data to be delivered to the mobile communication terminal 93.

In contrast, in the case where, after communicating with both of the wireless base stations at the same time as described above, the mobile communication terminal 93 returns to the communication area of the handover origin wireless base station 91, the subordinate apparatus 61 transmits the control signal 72 indicating a stop of the transmission to the handover destination wireless base station 92. As a result, the data stored in the handover origin wireless base station 91 is cleared from the buffer, and also, communication between the mobile communication terminal 93 and the handover origin wireless base station 91 is started.

As explained above, in the communication system according to the fourth embodiment, while the ARQ for the wireless section is terminated by one of the wireless base stations, the communication is handed over to the other wireless base station, without having to hand over the status in which the ARQ is performed from the one of the wireless base stations to the other. In addition, when the communication is handed over, control is exercised so that the transmission data signal to be delivered to the mobile communication terminal is transmitted from both of the base station apparatuses. Thus, it is possible to achieve a diversity effect between the wireless base stations, and also, it is possible to prevent or inhibit degradation of the user throughput related to the handovers.

Fifth Embodiment

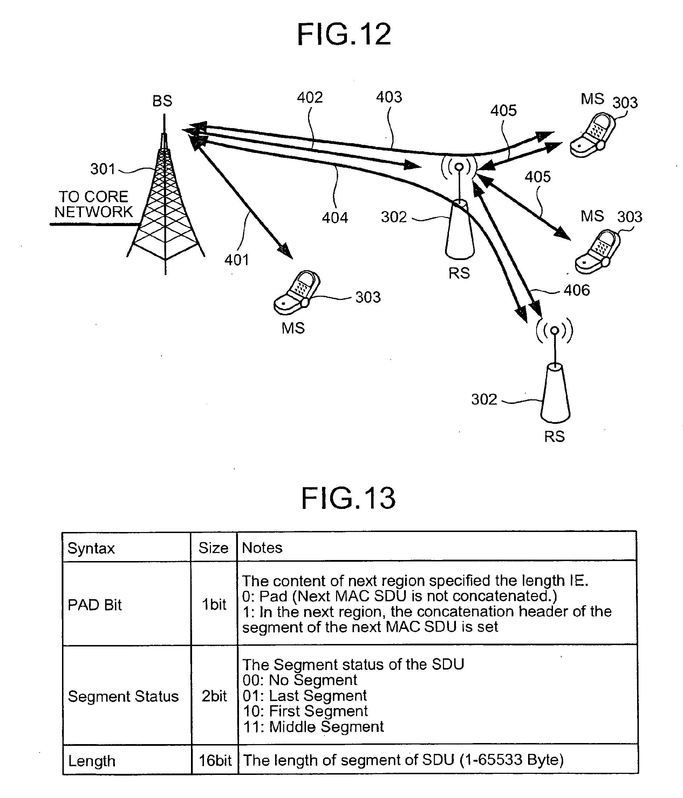

Next, a communication system according to a fifth embodiment of the present invention will be explained, with reference to the each of Figs. 12 to 23. The communication system according to the fifth embodiment is obtained by applying the communication system according to the first embodiment to the IEEE 802.16 standard (including modifications according to the fifth embodiment) described in the Non-patent Documents 2 and 3 listed below. However, the fifth embodiment is not limited to the example in which the communication system is applied to IEEE 802.16. Needless to say, it is acceptable to apply the fifth embodiment to any other communication systems.

Non-patent Document 2: IEEE Std 802.16-2004, "Air Interface for Fixed Broadband Wireless Access Systems", 2004 Non-patent Document 3: IEEE Std 802.16e-2005 and IEEE Std 802.16-2004/Cor1-2005, "Air Interface for Fixed and Mobile Broadband Wireless Access Systems", 2005

Fig. 12 is a drawing of a configuration of a mobile communication system for explaining the fifth embodiment and of communication connections that are made between the communication stations included in the mobile communication system. In the mobile communication system shown in Fig. 12, the communication stations such as a base station (hereinafter, "BS") 301, a mobile terminal (i.e., a mobile station which may be a subscriber station; hereinafter "MS") 303, and a relay station (hereinafter, "RS") 302 are positioned at required locations. Also, as the connections to which the fifth embodiment is applied, communication connections as the following are made: a BS-MS connection 401, a BS-RS connection 402, a BS-MS connection in which one or more arbitrary RSs intervene (e.g., a BS-MS connection 403), a BS-RS connection in which one or more arbitrary RSs intervene (e.g., a BS-MS connection 404), an RS-MS connection 405, and an RS-RS connection 406. According to the fifth embodiment, these communication connections will be expressed or referred to as Reliable Data Transfer (RDT) with Erasure Correction Code (ECC)-enabled Connections or RDT-enabled connections, or simply RDTs.

In the explanation of the fifth embodiment below, an example will be used in which the transmission data to be transmitted from the transmission-side communication apparatus to the reception-side communication apparatus is Medium Access Control Service Data Units (MAC_SDUs); however, the transmitted data may be Medium Access Control Protocol Data Units (MAC_PDUs) or other data in a superordinate layer.

In the first through the fourth embodiments, the configuration of the transmission data to be transmitted to the reception-side communication apparatus and the transmission controlling process were explained. However, according to the IEEE 802.16 standard, the term "concatenation" is used to refer to a process of generating desired transmission data from a plurality of pieces of data. Thus, in the explanation below, the term "concatenation" will be used.

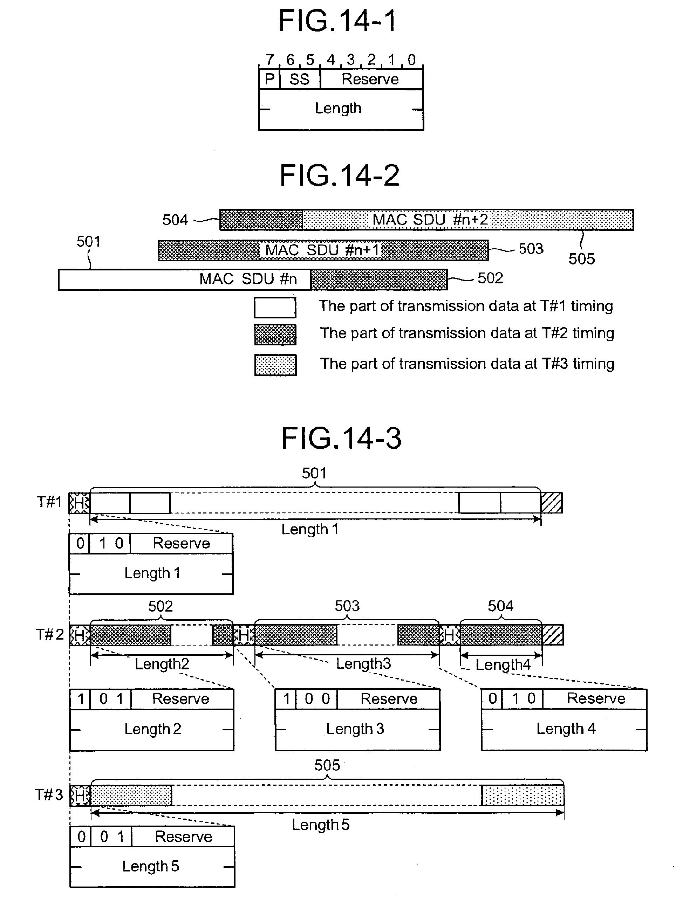

Next, the concatenations in the communication system according to the fifth embodiment will be explained, with reference to Figs. 13, 14-1, 14-2, and 14-3. Fig. 13 is a table of the contents defined in header information for concatenations. Fig. 14-1 is a diagram of a bit structure of the header information for concatenations. Fig. 14-2 is a diagram of an example of MAC_SDUs that constitute transmission data. Fig. 14-3 is a schematic diagram of a frame structure of a Reliable Data Transfer Service Data Unit (RDT_SDU) that is generated based on the MAC_SDUs shown in Fig. 14-2.

In Fig. 14-2, three MAC_SDUs (i.e., a MAC_SDU_#n, a MAC_SDU_#n+1, and a MAC_SDU_#n+2) are shown as the data to be transmitted from the transmission-side communication apparatus to the reception-side communication apparatus. For example, because of the correlation in the data length, the MAC_SDU_#n contains data 501 (having Length 1) that should be transmitted at a time T#1 and data 502 (having Length 2) that should be transmitted at a time T#2, whereas the MAC_SDU_#n+2 contains data 504 (having Length 4) that should be transmitted at the time T#2 and data 505 (having Length 5) that should be transmitted at the time T#2. Accordingly, as shown in Fig. 14-3, the RDT_SDU is structured in such a manner that the data that should be transmitted at the time T#1 contains only the data 501, whereas the data that should be transmitted at the time T#3 contains only the data 505. In contrast, the data that should be transmitted at the time T#2 contains the data 502, data 503, and the data 504.

Further, as shown in Fig. 14-3, header information as shown in Fig. 14-1 is appended to the head of each of the pieces of data to be concatenated. The header information includes, as shown in Figs. 13 and 14-1, information of the length ("Length"), information indicating whether another piece of data will be concatenated so as to be positioned after the piece of data having the indicated length (PAD_Bit: indicated as "P"), and information of segmentation (Segment_Status: indicated as "SS"). Thus, it is possible to apply the header information not only to concatenations, but also to segmentations. For example, as the header appended to the first piece of data (i.e., the data 502) within the data that should be transmitted at the time T#2, information such as P="1", SS="01", and Length="Length 2" is appended. Thus, it is understood that another MAC_SDU (i.e., the data 503) is positioned after the data 502, that the data 502 is the last piece of data ("Last_Segment") in the MAC_SDU (i.e., the MAC_SDU_#n), and that the data length of the data 502 is Length 2. As the header appended to the last piece of data (i.e., the data 504) within the data that should be transmitted at the time T#2, information such as P="0", SS="10", and Length="Length 4" is appended. Thus, it is understood that no other MAC_SDU follows the data 504, that the data 504 is the first piece of data ("First_Segment") in the MAC_SDU (i.e., the MAC_SDU_#n+2), and that the data length of the data 504 is Length 4.

Another arrangement is acceptable in which each of the MAC_SDUs above contains, in a mixed manner, pieces of data corresponding to a plurality of connections, as the pieces of data to be concatenated, for example, in a BS-RS connection or an RS-RS connection.

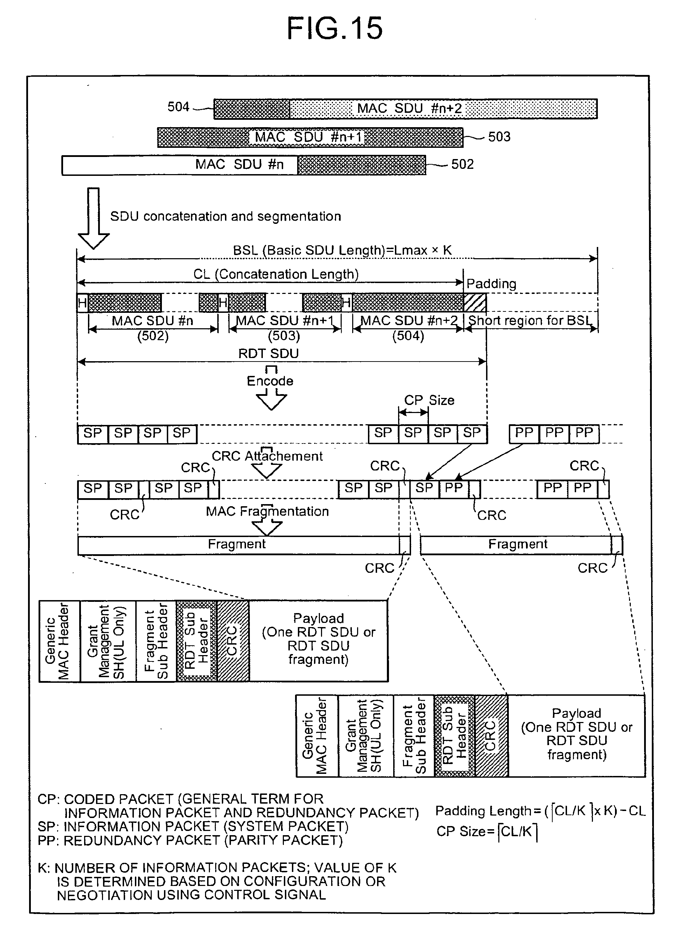

Next, a flow in the data processing to be performed on the transmission side will be explained, with reference to Fig. 15. Fig. 15 is a drawing of a concept of the flow in the data processing performed by the transmission-side communication apparatus. In this example, the pieces of data (data 502, 503, and 504) that are shown in Fig. 14-2 are used as the pieces of data (i.e., SDUs) to be concatenated.

As explained also in the first embodiment, in the communication system according to the fifth embodiment, the predetermined number (i.e., K) indicating how many packets are included in each information packet group (RDT_SDU) and the maximum length Lmax of each information packet group are determined in a one-to-one correspondence. In this situation, in the case where a predetermined amount of data having a length called Basic SDU Length (BSL) has been stored within a predetermined period of time, an information packet group that has the length BSL defined in the following expression is generated:

$$BSL = \text{the packet length Lmax} \times \text{the predetermined number K indicating the number of packets} \qquad (1)$$

The BSL defined in the expression above includes one or more padding bits used for adjusting the packet length.

On the other hand, in the case where the predetermined amount of data has not been stored within the predetermined period of time, an arrangement is acceptable in which the information packet group is generated by using the stored data and adding required padding bits, as necessary. By performing this process, it is possible to reduce the delay amount related to the storing of the data.

Also, in the example above, the predetermined number K indicating the number of packets and the packet length Lmax are the values that are determined for the system in a one-to-one correspondence. Alternatively, however, it is acceptable to use values that are determined by the system when the connection is established.

Returning to the description of Fig. 15, in the information packet group that has been generated as the RDT_SDU, the length of the portion including the plurality of MAC_SDUs and the header information thereof is defined as a Concatenation Length (CL). In this situation, it is possible to express the size of the packet (hereinafter "CP") that is generated through an erasure correction encoding process, by using the following expression based on the CL:

$$CP\_Size = \text{Celing}(CL/K) \qquad (2)$$

In the expression above, Celing(a) denotes a ceiling function, which is a function that defines, with respect to a real number "a", a smallest integer that is equal to or larger than the real number "a".

Further, it is possible to express the length of the padding bits (i.e., Padding_Length) to be inserted into the RDT_SDU, by using the following expression:

$$Padding\_Length = (CP\_Size \times K) - CL \qquad (3)$$

At the following step in the process, a packet (sometimes referred to as an information packet (SP) so as to be distinguished from a redundancy packet "PP") that has a size expressed by CP_Size and on which an erasure correction encoding process has been performed based on the data in the RDT_SDU (including the padding bits) is generated. It is possible to adjust, in an arbitrary manner, the number and the size of the generated erasure correction coded packets. For example, as explained in the description of the first embodiment, it is acceptable to increase or decrease the number of erasure correction coded packets corresponding to the coding rate of "1", without changing the packet size of each of the erasure correction coded packets. Alternatively, it is also acceptable to increase or decrease the packet size of each of the erasure correction coded packets, without changing the number erasure correction coded packets corresponding to the coding rate of "1".

It is preferable to have an arrangement in which the number of erasure correction coded packets to be transmitted first is determined by adding as many redundancy packets (PPs) as a constant number $\alpha$ to the information packets (SPs). The constant number $\alpha$ may be a value that is configured for the system in a one-to-one correspondence or may be determined according to judgment based on transmission path information.

After the erasure correction coded packets have been generated, a CRC code is appended to one or more of the erasure correction coded packets. Also, a packet (called a "fragment") is generated by connecting together a plurality of erasure correction coded packets to which the CRC code has been appended, according to the scheduled amount. Appended to the set of packets (i.e., the fragment) are a General_MAC header and a fragmentation sub-header/packing sub-header that are defined in the standards described in the Non-patent Documents listed above. A MAC_PDU to which, in addition to these sub-headers, an RDT sub-header that is newly defined according to the fifth embodiment is appended is generated. The generated MAC_PDU is transmitted to the reception side. It is also acceptable to append, as necessary, a CRC code for the header to the MAC_PDU. Also, another arrangement is acceptable in which a CRC code is appended in units that are variable for each connection or for each frame, depending on the state of the transmission path. As a result of this process, it is possible to balance the transmission efficiency and the error detection efficiency and to improve the throughput.

In the process described above, the MAC_PDU is generated by connecting together the units each of which is obtained by appending a CRC code to the one or more erasure correction coded packets. However, another arrangement is acceptable in which the MAC_PDU is generated by separating the erasure correction coded packets according to the partitions therein.

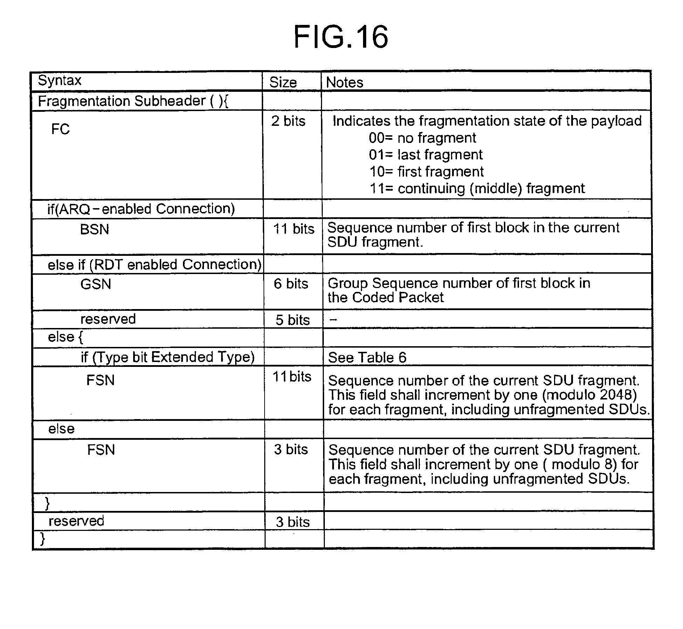

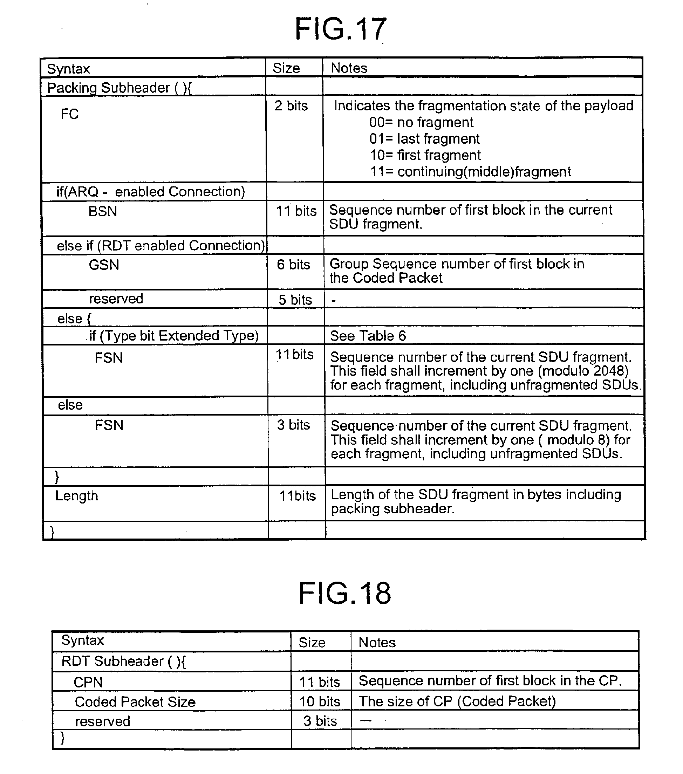

Next, the fragmentation sub-header and the packing sub-header that are defined in the IEEE 802.16 standard and modified so as to be applied to the fifth embodiment as well as the RDT sub-header that is newly defined so as to be applied to the fifth embodiment will be explained. Fig. 16 is a table of the contents defined in the fragmentation sub-header. Fig. 17 is a table of the contents defined in the packing sub-header. Fig. 18 is a table of the contents defined in the RDT sub-header.

According to the fifth embodiment, a Group Sequence Number (GSN) is contained in the fragmentation sub-header and in the packing sub-header. By using the Group Sequence Number (GSN), even if the transmission-side communication apparatus transmits erasure correction coded packets having mutually different GSNs in parallel, the reception-side communication apparatus is able to recognize the fragmentation and the packing by using, as a unit, a group of erasure correction coded packets that is transmitted initially or additionally in correspondence with a certain GSN.

Also, because the RDT sub-header contains a packet number (i.e., a CPN) for the erasure correction encoding process and the size of each of the erasure correction coded packets, it is possible to identify the erasure correction coded packets on the reception side. Thus, it is also possible to change the size of each of the erasure correction coded packets depending on the transmission traffic and to improve the transmission efficiency. Another arrangement is acceptable in which the units in which the CRC code is appended to the erasure correction coded packets and the type of the CRC code may be configured for each system in a one-to-one correspondence or may be determined when the connection is established. Further, yet another arrangement is acceptable in which the units in which the CRC code is appended and the type of CRC code are notified to the reception side by using a control signal in an extended sub-header or the like. In addition, in the case where the size of each of the erasure correction coded packets is very small, it is acceptable to connect together a larger number of erasure correction coded packets than the predetermined number. However, it is preferable to append a CRC code at the end of every MAC_PDU.

On a CRC code appended to a header, it is possible to perform a process that is the same as the one performed on the CRC code appended to the erasure correction coded packets. More specifically, it is possible to select, as necessary, one of the following depending on the situation: the units in which the CRC code is appended and the type of the CRC code are (a) configured for each system in a one-to-one correspondence, (b) determined when the connection is established, and (c) notified to the reception side by using a control signal.

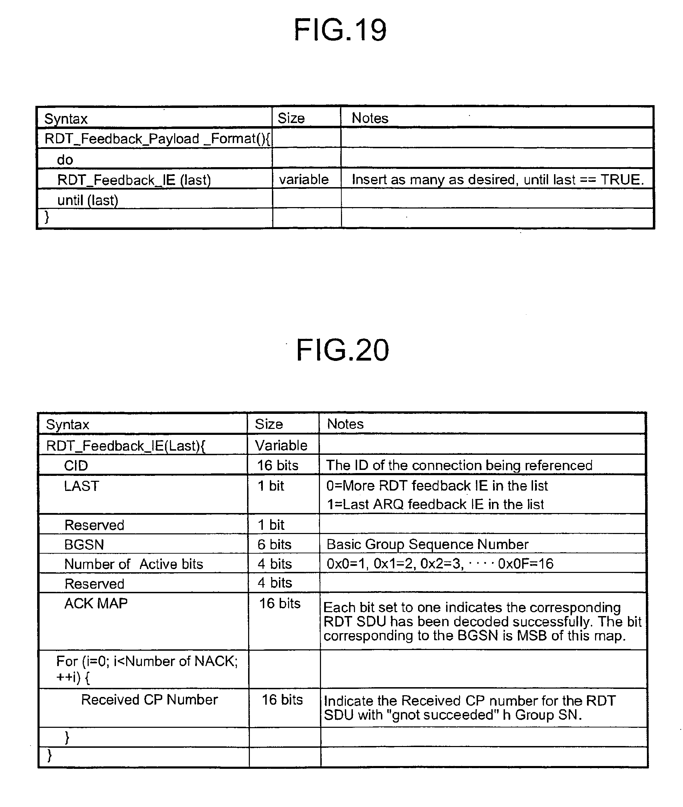

Next, the feedback information that is transmitted from the reception-side transmission apparatus to the transmission-side communication apparatus will be explained, with reference to Figs. 19 and 20. Fig. 19 is a table of the contents defined as a transmission condition for the feedback information that is transmitted from the reception-side transmission apparatus to the transmission-side communication apparatus. Fig. 20 is a table of the detailed contents defined as the feedback information shown in Fig. 19.

When the feedback information transmitted from the reception-side transmission apparatus has been received by the transmission-side communication apparatus, because delivery confirmations have already been completed for the Basic Group Sequence Number (BGSN: see Fig. 20) for which a delivery conformation completion (ACK) has been indicated and for other GSNs of which the numerical values are smaller than the BGSN, these erasure correction coded packets will not be additionally transmitted. On the other hand, as for the GSNs for which a delivery confirmation incompletion (NACK) has been indicated, the erasure correction coded packets corresponding to these GSNs are additionally transmitted because the delivery confirmations have not been completed. In this situation, by having an arrangement in which the feedback information transmitted from the reception-side transmission apparatus contains the number of erasure correction coded packets that have successfully been received on the reception side, the transmission side does not have to transmit an excessive number of erasure correction coded packets. It is sufficient to additionally transmit as many erasure correction coded packets as "the number of information packets - the number of received erasure correction coded packets + β". In this situation, the value of "β" may be configured for each system in a one-to-one correspondence or may be determined when the connection is established. Also, it is acceptable to increase (e.g., multiply) the value of "β", according to the number of times the additional transmission is performed. By specifying the value of "β" so as to be an appropriate value or so as to be variable, it is possible to effectively enhance the transmission efficiency for the erasure correction coded packets.

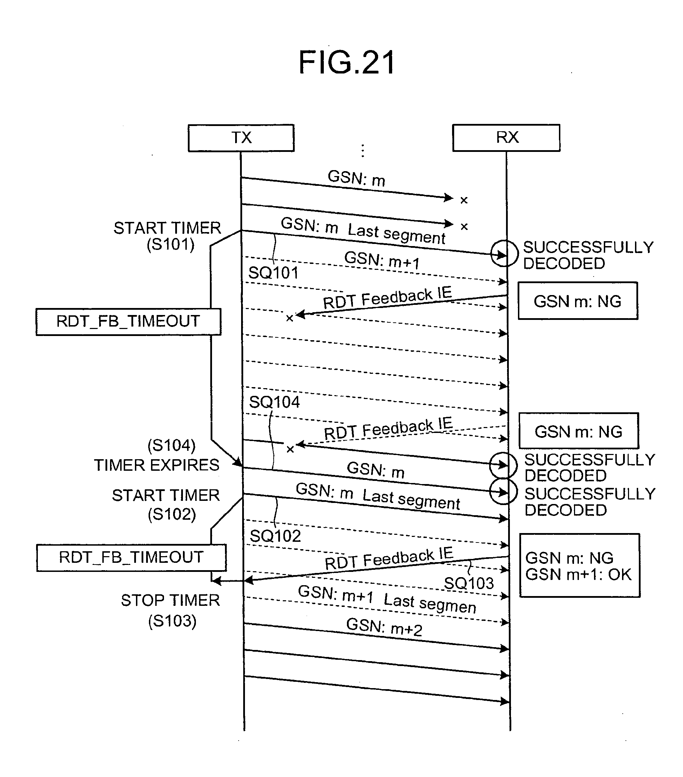

In consideration of a situation where the feedback information is lost, it is preferable to exercise transmission control by using a timer on the transmission side. The flow in this process is shown in Fig. 21. In Fig. 21, when the last MAC_PDU for a GSN is initially or additionally transmitted (sequence SQ101 and SQ102), the timer (RDT_FB_TIMEOUT) is activated (steps S101 and S102). When the feedback information has been received (sequence SQ103), the timer is stopped (step S103). On the other hand, in the case where the timer has expired before the feedback information is received (step S104), as many erasure correction coded packets as γ are additionally transmitted, without waiting to receive the feedback information (sequence SQ104). The value of γ may be configured for each system in a one-to-one correspondence or may be determined when the connection is established. Also, it is acceptable to increase (e.g., multiply) the value of "γ", according to the number of times the additional transmission is performed. By specifying the value of "γ" so as to be an appropriate value or so as to be variable, it is possible to effectively enhance the transmission efficiency for the erasure correction coded packets.

As for the number of times the additional transmission is performed, it is possible to specify the number of times so as to be a predetermined value that is equal to or larger than one, based on the QoS information of the connection, the transmission path information, or the like. Also, for example, in the case where the quality of the transmission path is good, needless to say, it is acceptable to specify the number of times the additional transmission is performed so as to be zero. Additionally, it is preferable to have an arrangement in which the number of coded packets transmitted from the transmission side is limited to the maximum number of coded packets that is determined based on the coding rate for the erasure correction code. For example, in the case where a code having a coding rate of 1/2 is used, twice as many erasure correction coded packets as the number of information packets are generated. Thus, when the transmission of all of the erasure correction coded packets have been completed, the additional transmission should be terminated.

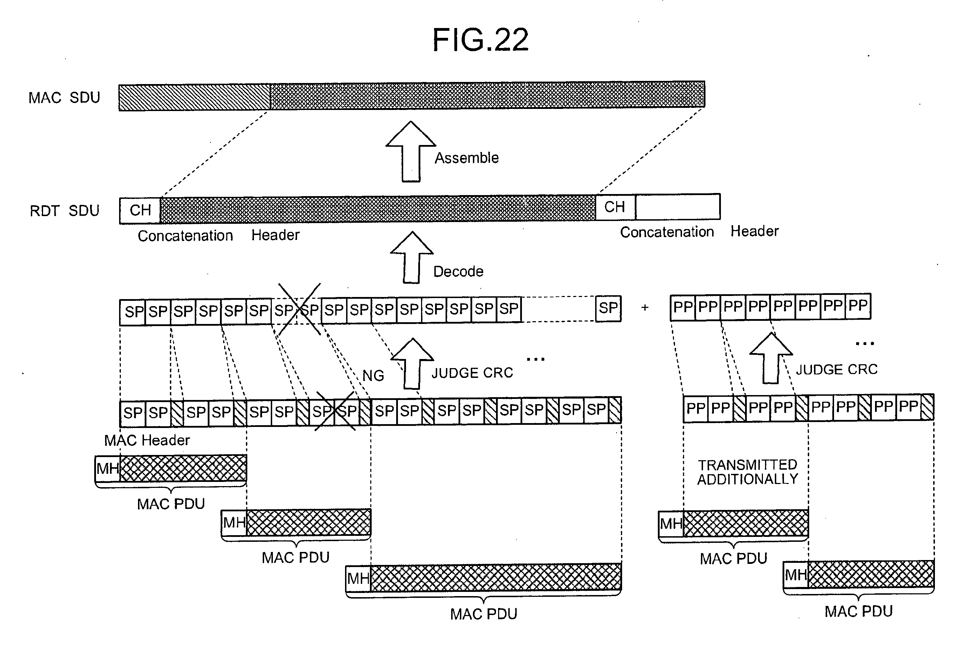

Fig. 22 is a drawing of a concept of the flow in the data processing performed by the reception-side communication apparatus. In Fig. 22, a header analysis is performed on the received MAC_PDUs, and after the positions of the CRC codes have been recognized, a CRC code judgment process is performed. In the case where the result of the CRC code judgment process is not good, the one or more erasure correction coded packets being the target are discarded. After that, by using only the received erasure correction coded packets, an erasure correction decoding process is performed. As for whether the decoding process should be performed when a MAC_PDU corresponding to a new GSN has been received, it is preferable to judge that the decoding process should be performed if the total number of erasure correction coded packets received in correspondence with the GSN exceeds the number of information packets.

In the case where the received erasure correction coded packets have successfully been decoded, the concatenation header (CH) in the reproduced information packet group (RDT_SDU) is analyzed. Also, the concatenations and the segmentations are cancelled so that the MAC_SDUs are reproduced. The reproduced MAC_SDUs are transferred to a superordinate layer either after order control is exercised in the case where it is necessary or the way they are in the case where order control is not necessary.

On the other hand, in the case where the decoding process has not successfully been performed, if the total number of received erasure correction coded packets has not reached the number of information packets, it is preferable to retain all the erasure correction coded packets or to perform concatenation and segmentation processes by using only the information packets that have successfully been reproduced and wait for erasure correction coded packets to be additionally transmitted. After that, when the erasure correction coded packets that are additionally transmitted have been received, the decoding procedure described above is performed on the received packets together with the erasure correction coded packets that have previously been received.

The feedback information may be transmitted to the transmission side either at regular intervals or when the decoding process has been performed.

The setting for the delivery confirmation completion (ACK) is started when the decoding for the corresponding GSN has been completed.

The setting for the delivery confirmation incompletion (NACK) is started when, for example, one of the following situation arises:

(1) Although a MAC_PDU corresponding to the last fragment has been received among the MAC_PDUs that have mutually the same GSN and are initially transmitted, the total number of received erasure correction coded packets has not reached the number of information packets;

(2) Even if the total number of erasure correction coded packets that have successfully been received in correspondence with a certain GSN has not reached the number of information packets, an erasure correction coded packet having a new GSN is to be received;

(3) In the case where the timer is activated after a MAC_PDU having a new GSN has been received, and the timer has expired before the conditions described above including the delivery confirmation completion are satisfied.

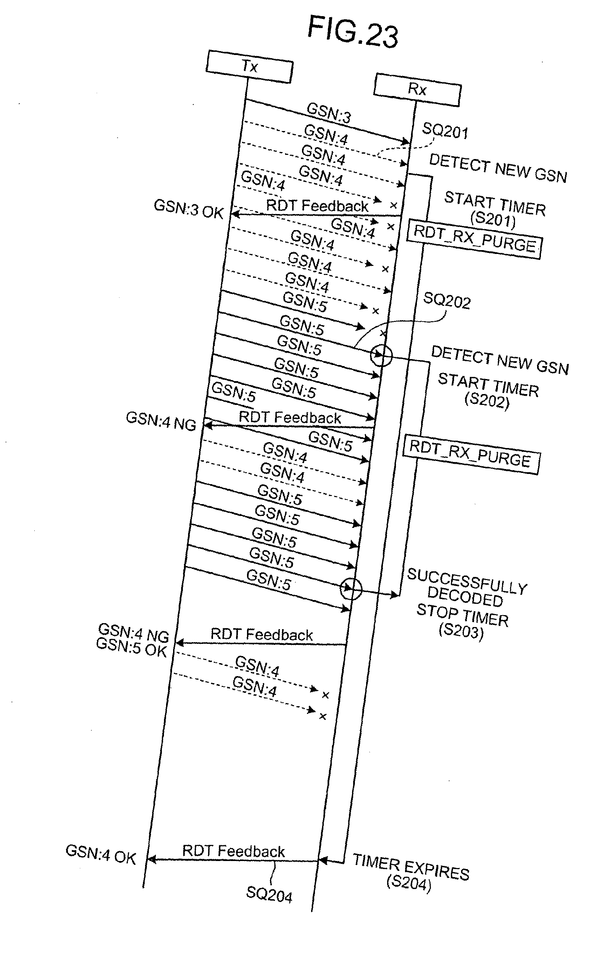

Fig. 23 is a diagram of a communication flow used by the reception-side communication apparatus when the transmission control is exercised by using a timer. The processes based on this flow are performed to solve the problem where the delay becomes larger when the decoding process for a certain GSN does not get completed on the reception side.

In Fig. 23, in the reception-side communication apparatus, when an erasure correction coded packet having a new GSN has been received (sequence SQ201 and SQ202), the timer (RDT_RX_PURGE) is activated (steps S201 and S202). When the decoding process for the GSN has been completed, the timer is stopped (step S203). On the other hand, when the timer has expired (step S204), either all of the received erasure correction coded packet having the GSN are discarded or after reproducible information packets are reproduced MAC_SDUs are generated by performing the concatenation and the segmentation processes up to a point where it is possible. After that, the delivery completion is notified to the transmission side by using feedback information (sequence SQ204).

In the case where it is desired that the decoding process corresponding to the GSN should be terminated on the reception side before the purge timer (RDT_RX_PURGE) on the reception side expires when, for example, the additional transmission is no longer performed on the transmission side, it is acceptable to make a request to the reception side that the decoding process should be terminated by exchanging control signals.

In addition, in the case where it has been judged on the transmission side or on the reception side that the GSNs or the like are not synchronized, it is acceptable to reset various types of status and parameters used in the transmission control, by exchanging control signals.

Sixth Embodiment

Next, a communication system according to a sixth embodiment of the present invention will be explained, with reference to Figs. 14-1, 24, and 25. The sixth embodiment corresponds to an example in which, according to the fifth embodiment, the transmission data transmitted from the transmission-side communication apparatus to the reception-side communication apparatus through an RDT_with_ECC-enabled Connection are MAC_PDUs.

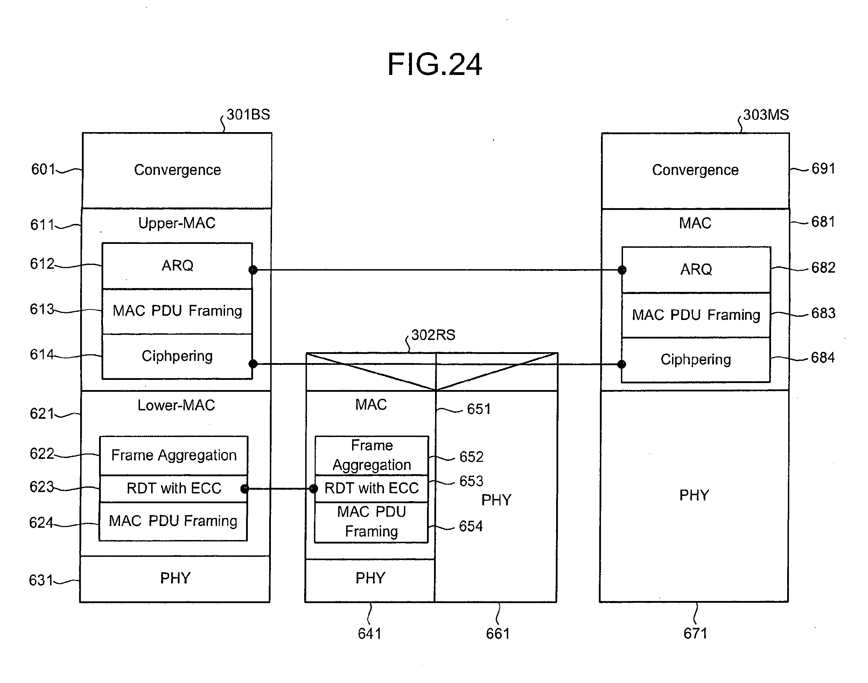

Fig. 24 is a diagram of an example of a user plane protocol stack, used for explaining the sixth embodiment; however, the sixth embodiment is not limited to the example with the protocol stack.

The BS 301 has, as the layers that are subordinate to a convergence sub-layer 601, an Upper-MAC layer 611 used for forwarding MAC_PDUs to the MS 303, a Lower-MAC layer 621 used for forwarding MAC_PDUs to the RS 302, and a physical layer 631. The Upper-MAC layer 611 has an ARQ function 612, a MAC_PDU generating (i.e., framing) function 613, and a ciphering function 614. The Lower-MAC layer has a frame aggregation function 622 as well as an RDT_with_ECC function 623 and a MAC_PDU generating (i.e., framing) function 624 that are explained in the description of the fifth embodiment.

The RS 302 has: a MAC layer 651 that is used for forwarding MAC_PDUs to the BS 301 and processes superordinate data between the RS 302 and the MS 303 in a transparent manner; a physical layer 641 on the BS 301 side; and a physical layer 661 on the MS 303 side. Like the Lower-MAC layer 621 included in the BS 301, the MAC layer 651 has a frame aggregation function 652, an RDT_with_ECC function 653, and a MAC_PDU generating (i.e., framing) function 654.

The MS 303 has, as the layers that are subordinate to a convergence sub-layer 691, a MAC layer 681 used for forwarding MAC_PDUs to the BS 301, and a physical layer 671. Like the Upper-MAC layer 611 included in the BS 301, the MAC layer 681 has an ARQ function 682, a MAC_PDU generating function 683, and a ciphering function 684.

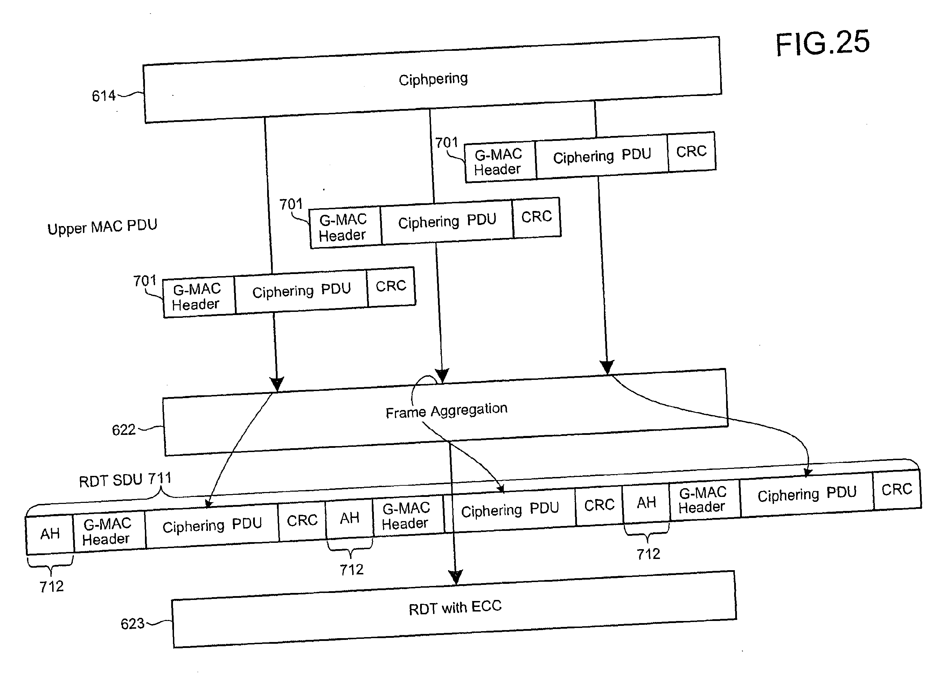

Fig. 25 is a diagram of a process flow in the transmission process performed by the BS 301, depicting the flow from the ciphering function 614 to the frame aggregation function 622. For the purpose of connecting together the generated MAC_PDUs the way they are, which have been generated by having the data portions thereof ciphered by the ciphering function 614, an aggregation header 712 is positioned at the head of each of the PDUs so that an RDT_SDU 711 is generated. In this situation, the aggregation header 712 may be the same as the concatenation header that is shown in Fig. 14-1 and explained in the description of the fifth embodiment or may be another type of header used for connecting the MAC_PDUs together. The processes that are performed after the RDT_SDU 711 is generated are the same as the ones according to the fifth embodiment.

According to the sixth embodiment, the RS 302 does not need to have any key for the ciphering process. In addition, even if the RS 302 is introduced between the BS 301 and the MS 303, the BS 301 is able to use a conventional MAC layer as the Upper-MAC layer 611 without the need to modify it, while the Lower-MAC layer 621 is added to the configuration. Thus, an advantageous effect is achieved where there is no need to modify the MS 303.

INDUSTRIAL APPLICABILITY

As explained above, the communication system, the transmission-side communication apparatus and the reception-side communication apparatus according to the present invention are especially useful in the application to a communication system and the apparatuses included in the communication system that use the Automatic Repeat reQuest (ARQ) method in which the reception side automatically makes a request to the transmission side that transmission data should be re-transmitted.

**Claims**

1. A communication system in which a reception-side communication apparatus makes a request to a transmission-side communication apparatus that a transmission data signal be re-transmitted, wherein
the transmission-side communication apparatus includes:

   a transmission scheduling unit that determines a transmission amount to be transmitted, at least, to the reception-side communication apparatus;
   an erasure correction encoding unit that performs an erasure correction encoding process on an information packet group that is made up of a plurality of packets to be transmitted so as to generate one or more erasure correction coded packets that fit the transmission amount instructed by the transmission scheduling unit and specifies the one or more erasure correction coded packets as a unit of delivery confirmation; and
   a transmitting unit that transmits the transmission data signal that has been generated by performing a predetermined modulation process on each of the erasure correction coded packets, and
   the reception-side communication apparatus includes:

   an erasure correction decoding unit that generates the information packet group by performing an erasure correction decoding process on the transmission data signal that has been received and generates, in a case where the erasure correction decoding process has successfully been performed on the transmission data signal, a reception completion signal indicating that reception of the transmission signal has been completed for each unit of delivery confirmation; and
   a transmitting unit that transmits a delivery confirmation signal that has been generated based on the reception completion signal.

2. The communication system according to claim 1, wherein the erasure correction encoding unit assigns a series of sequence numbers to the one or more erasure correction coded packets based on an instruction from the transmission scheduling unit and continues to transmit the one or more erasure correction coded packets until receiving the delivery confirmation signal from the reception-side communication apparatus.

3. The communication system according to claim 2, wherein the erasure correction encoding unit specifies an upper limit value for the series of sequence numbers assigned to the one or more erasure correction coded packets so that, in a case where all of erasure correction coded packets corresponding to a set of sequence numbers prepared in advance have been transmitted, the erasure correction coded packets are re-transmitted from a first one of the set of sequence numbers.

4. The communication system according to claim 1, wherein the erasure correction decoding unit discards erasure correction coded packets that are received after the decoding process has been completed and have already been decoded.

5. The communication system according to claim 1, wherein the erasure correction encoding unit fits the one or more erasure correction coded packets into a transmission frame according to a communication capacity of a physical layer.

6. The communication system according to claim 1, wherein the erasure correction encoding unit changes how many erasure correction coded packets that are generated by the erasure correction encoding unit correspond to a coding rate of 1, based on QoS information about a connection established between the transmission-side communication apparatus and the reception-side communication apparatus.

7. The communication system according to claim 1, wherein the erasure correction encoding unit changes a size of each of the erasure correction coded packets generated by the erasure correction encoding unit, without changing how many erasure correction coded packets that are generated by the erasure correction encoding unit correspond to a coding rate of 1, based on QoS information about a connection established between the transmission-side communication apparatus and the reception-side communication apparatus.

8. The communication system according to claim 1, wherein the transmission scheduling unit selects a modulation method that has a lower error rate, according to an increase in a value indicating how many erasure correction coded packets are contained in the information packet group.

9. The communication system according to claim 1, wherein
the transmission-side communication apparatus and the reception-side communication apparatus are able to communicate with each other based on one selected out of a plurality of channels that use a mutually same communication access method, a plurality of communication access methods, and a combination thereof,
for the one or more erasure correction coded packets, the transmission scheduling unit selects one out of the plurality of channels that use mutually the same communication access method, the plurality of communication access methods, and the combination thereof,
the erasure correction encoding unit generates the erasure correction coded packets, based on the channels or the communication access methods instructed by the transmission scheduling unit, and
the erasure correction decoding unit puts together the received erasure correction coded packets individually for each of the channels or the communication access methods that have been selected on the transmission-side communication apparatus side and performs the decoding process thereon.

10. The communication system according to claim 9, wherein the delivery confirmation signal is transmitted to the transmission-side communication apparatus being a transmission origin, through a channel or a communication access method that has good quality.

11. The communication system according to claim 1, wherein
the transmission-side communication apparatus includes a plurality of communication devices,
one of the communication devices generates, while ensuring that the plurality of communication devices are synchronized with one another, erasure correction coded packets that have a series of sequence numbers that is different from any of series of sequence numbers assigned to erasure correction coded packets generated by other ones of the communication devices, and
the reception-side communication apparatus puts together the received erasure correction coded packets individually for each of the communication devices included in the transmission-side communication apparatus and performs the decoding process thereon.

12. The communication system according to claim 11, wherein the delivery confirmation signal is transmitted to the communication devices included in the transmission-side communication apparatus.

13. The communication system according to claim 11, wherein
in a case where at least one of the communication devices included in the transmission-side communication apparatus functions as a handover origin wireless base station, whereas another one of the communication devices functions as a handover destination wireless base station, while the reception-side communication apparatus functions as a mobile communication terminal, processes of controlling the assigning of the series of sequence numbers to the erasure correction coded packets and controlling a start and a stop of the transmission to the mobile communication terminal are performed, based on an instruction from an apparatus that is superordinate to the transmission-side communication apparatus.

14. The communication system according to claim 1, wherein the transmission-side communication apparatus and the reception-side communication apparatus each include an error correction encoding section that performs an error correction encoding process to packets on which the erasure correction encoding process has not yet been performed and an error correction decoding section that performs an error correction decoding process on packets on which the erasure correction encoding process has been performed.

15. A transmission-side communication apparatus that performs predetermined communication with a reception-side communication apparatus that makes a request that a transmission data signal be re-transmitted, the transmission-side communication apparatus, comprising:

a transmission scheduling unit that determines a transmission amount to be transmitted, at least, to the reception-side communication apparatus;

an erasure correction encoding unit that performs an erasure correction encoding process on an information packet group that is made up of a plurality of packets to be transmitted so as to generate one or more erasure correction coded packets that fit the transmission amount instructed by the transmission scheduling unit and specifies the one or more erasure correction coded packets as a unit of delivery confirmation; and

a transmitting unit that transmits the transmission data signal that has been generated by performing a predetermined modulation process on each of the erasure correction coded packets, wherein

re-transmission to the reception-side communication apparatus performed by the erasure correction encoding unit is controlled based on a delivery confirmation signal that is notified to the erasure correction encoding unit for each unit of delivery confirmation when the reception-side communication apparatus has successfully performed an erasure correction decoding process on the transmission data signal that has been transmitted to the reception-side communication apparatus.

16. The transmission-side communication apparatus according to claim 15, wherein the erasure correction encoding unit assigns a series of sequence numbers to the one or more erasure correction coded packets based on an instruction from the transmission scheduling unit and continues to transmit the one or more erasure correction coded packets until receiving the delivery confirmation signal from the reception-side communication apparatus.

17. A reception-side communication apparatus that receives a transmission data signal from a transmission-side communication apparatus and, in a case where reception of the transmission data signal does not get completed, makes a request that the transmission data signal be re-transmitted, the reception-side communication apparatus comprising:

an erasure correction decoding unit that receives the transmission data signal containing one or more erasure correction coded packets that have been generated by an erasure correction encoding process on an information packet group made up of a plurality of packets to be received, so as to fit a transmission amount determined based on a predetermined unit of delivery confirmation, generates the information packet group by performing an erasure correction decoding process on the received transmission data signal, and generates, in a case where the erasure correction decoding process has successfully been performed on the transmission data signal, a reception completion signal indicating that the reception of the transmission data signal has been completed for each unit of delivery confirmation; and

a transmitting unit that transmits a delivery confirmation signal that has been generated based on the reception completion signal.

18. The reception-side communication apparatus according to claim 17, wherein the erasure correction decoding unit discards erasure correction coded packets that are received after the decoding process has been completed and have already been decoded.

19. The communication system according to claim 1, wherein

the erasure correction encoding unit appends a CRC code by using the one or more erasure correction coded packets as a unit of appending, and

the unit of appending is variable for each connection or for each frame, according to a state of a transmission path.

20. The communication system according to claim 1, wherein

the erasure correction encoding unit activates a timer when a data storing process for generating the information packet group is started, and

in a case where the timer has expired before stored data reaches a predetermined amount, the erasure correction encoding unit generates the information packet group by using the data that has been stored up to that point in time.

21. The communication system according to claim 20, wherein the erasure correction encoding unit performs the encoding process on the information packet group that has been generated by using the stored data and adding, as necessary, one or more padding bits that are required, by using, as a unit of encoding, a packet size obtained by dividing the information packet group into a predetermined number of packets.

22. The communication system according to claim 1, wherein

the erasure correction encoding unit includes a plurality of buffers that are operable to process, in parallel, a plurality of information packet groups corresponding to each unit of delivery confirmation, and

the erasure correction decoding unit includes a plurality of buffers that are operable to process, in parallel, a plurality of information packet groups corresponding to each unit of delivery confirmation.

**23.** The communication system according to claim 22, wherein
the transmission-side communication apparatus determines how many erasure coded packets should be initially transmitted and transmits as many erasure correction coded packets as determined to the reception-side communication apparatus and refrains from transmitting erasure correction coded packets that should additionally be transmitted until receiving feedback information from the reception-side communication apparatus,
the reception-side communication apparatus transmits the feedback information to a transmission side at regular intervals or at an arbitrary time, and
the transmission-side communication apparatus refers to the received feedback information and determines how many erasure correction coded packets should additionally be transmitted with respect to the information packet groups of which delivery has not been completed.

**24.** The communication system according to claim 23, wherein
the feedback information includes information indicating either a delivery has been completed or the delivery has not been completed, and
the information indicating that the delivery has not been completed includes information that shows how many coded packets have successfully been received by the reception-side communication apparatus.

**25.** The communication system according to claim 23, wherein
the erasure correction encoding unit activates a timer when the erasure correction coded packets are transmitted, and
in a case where the timer has expired before the feedback information has been received, the erasure correction encoding unit additionally transmits the erasure correction coded packets without waiting to receive the feedback information.

**26.** The communication system according to claim 23, wherein a number indicating how many erasure correction coded packets are to be additionally transmitted is increased according to a number indicating how many times the additional transmission is performed.

**27.** The communication system according to claim 23, wherein a number indicating how many times the additional transmission of the erasure correction coded packets is performed is limited to a predetermined value.

**28.** The communication system according to claim 23, wherein a number indicating how many coded packets are transmitted from the transmission side is limited to a maximum number of coded packets that is determined based on a coding rate for an erasure correction code.

**29.** The communication system according to claim 23, wherein
the erasure correction decoding unit activates a timer used for purging the erasure correction coded packets, and
in a case where the timer has expired before the decoding process has successfully been performed on the erasure correction coded packets, the erasure correction decoding unit determines whether all of the received erasure correction coded packets should be discarded or only reproducible information packets should be reproduced and notifies the transmission-side communication apparatus of a delivery completion by using the feedback information.

**30.** The communication system according to claim 29, wherein the erasure correction decoding unit determines whether all of the received erasure correction coded packets should be discarded or only the reproducible information packets should be reproduced, based on an instruction provided from the transmission-side communication apparatus side.

**31.** The communication system according to claim 23, wherein at least various states of the connection and the series of sequence numbers are reset according to a mutual instruction from the transmission-side communication apparatus or the reception-side communication apparatus.

# FIG.1

TRANSMISSION-SIDE COMMUNICATION APPARATUS ⌐11

TRANSMISSION SCHEDULING UNIT ⌐113

IP PACKETS 31

DATA STORING UNIT ⌐111

ERASURE CORRECTION ENCODING UNIT ⌐112

BUFFER 112a

ERROR CORRECTION ENCODING UNIT ⌐114

MODULATING UNIT ⌐115

TRANSMISSION DATA SIGNAL 41

ERROR CORRECTION DECODING UNIT 117

DEMODULATING UNIT 116

COMMUNICA-TION PATH 51

RECEPTION-SIDE COMMUNICATION APPARATUS ⌐21

IP PACKETS 32

IP PACKET REPRODUCING UNIT 214

ERASURE CORRECTION DECODING UNIT ⌐213

BUFFER 213a

ERROR CORRECTION DECODING UNIT ⌐212

DEMODULATING UNIT ⌐211

DELIVERY CONFIRMATION SIGNAL 42

ERROR CORRECTION ENCODING UNIT 215

MODULATING UNIT 216

EP 1 962 450 A1

# FIG.2

SEQUENTIALLY TRANSMITTED

80

81    82

| 0 | 0 | Frame #1

| 1 | 1 | Frame #2

⋮

| 255 | 255 | Frame #256

WHEN ALL OF CODED PACKETS THAT CAN BE PREPARED HAVE BEEN TRANSMITTED, PACKETS ARE RE-TRANSMITTED STARTING WITH ONE WITH SEQUENCE NUMBER 0

# FIG.3

80

81    82

| 0-5 | 5 |

# FIG.4

RECEPTION-SIDE COMMUNICATION APPARATUS  21

ERASURE CORRECTION DECODING UNIT  213

213a

213b

TRANSMISSION-SIDE COMMUNICATION APPARATUS  11

ERASURE CORRECTION ENCODING UNIT  112

DATA STORING UNIT  111

112a

112b

# FIG.5

80

83

Frame #1 | 0 | 0 | 1 | 2 | 3 | CRC

81 82

Frame #2 | 4 | 4 | 5 | 6 | 7 | 8 | 9 | CRC

Frame #3 | 10 | 10 | 11 | 12 | CRC

# FIG.6

# FIG.7

$Pa = Pb$

$$\frac{Pa}{Sa} \rangle \frac{Pb}{Sb}$$

# FIG.8

$Pc \langle Pd$

$$\frac{Pc}{Sc} = \frac{Pd}{Sd}$$

# FIG.9

EP 1 962 450 A1

# FIG.10

**TRANSMISSION-SIDE COMMUNICATION APPARATUS** ~12

- TRANSMISSION SCHEDULING UNIT ~123
- DATA STORING UNIT ~121
- ERASURE CORRECTION ENCODING UNIT ~122
  - BUFFER ~112a
- ERROR CORRECTION ENCODING UNIT ~124
- MODULATING UNIT ~125
- ERROR CORRECTION DECODING UNIT ~127
- DEMODULATING UNIT ~126

IP PACKETS 31

TRANSMISSION DATA SIGNAL ~43

**TRANSMISSION-SIDE COMMUNICATION APPARATUS** ~11

- TRANSMISSION SCHEDULING UNIT ~113
- DATA STORING UNIT ~111
- ERASURE CORRECTION ENCODING UNIT ~112
  - BUFFER ~112a
- ERROR CORRECTION ENCODING UNIT ~114
- MODULATING UNIT ~115
- ERROR CORRECTION DECODING UNIT ~117
- DEMODULATING UNIT ~116

IP PACKETS 31

TRANSMISSION DATA SIGNAL 41

COMMUNICA-TION PATH 51

COMMUNICA-TION PATH 52

**RECEPTION-SIDE COMMUNICATION APPARATUS** ~21

- IP PACKET REPRODUCING UNIT ~214
- ERASURE CORRECTION DECODING UNIT ~213
  - BUFFER ~213a
- ERROR CORRECTION DECODING UNIT ~212
- DEMODULATING UNIT ~211
- ERROR CORRECTION ENCODING UNIT ~215
- MODULATING UNIT ~216

IP PACKETS 32

SUPERORDINATE APPARATUS 61

DELIVERY CONFIRMATION SIGNAL ~42

DELIVERY CONFIRMATION SIGNAL 44

EP 1 962 450 A1

FIG.11

# FIG.12

# FIG.13

| Syntax | Size | Notes |
|---|---|---|
| PAD Bit | 1bit | The content of next region specified the length IE.<br>0: Pad (Next MAC SDU is not concatenated.)<br>1: In the next region, the concatenation header of the segment of the next MAC SDU is set |
| Segment Status | 2bit | The Segment status of the SDU<br>00: No Segment<br>01: Last Segment<br>10: First Segment<br>11: Middle Segment |
| Length | 16bit | The length of segment of SDU (1-65533 Byte) |

# FIG.14-1

```
 7 | 6 | 5 | 4 | 3 | 2 | 1 | 0
 P | SS  |    Reserve
          Length
```

# FIG.14-2

504 — MAC SDU #n+2

501

MAC SDU #n+1 — 503  505

MAC SDU #n — 502

☐ The part of transmission data at T#1 timing

▓ The part of transmission data at T#2 timing

▒ The part of transmission data at T#3 timing

# FIG.14-3

501

T#1 H ──────── Length 1 ────────►

```
 0 | 1 | 0 |   Reserve
         Length 1
```

502        503        504

T#2 H ▓▓ ▓H▓▓ ▓H ▓ ▒

|◄─ Length2 ─►| |◄─── Length3 ───►| |◄Length4►|

```
 1 | 0 | 1 |  Reserve        1 | 0 | 0 |  Reserve        0 | 1 | 0 |  Reserve
        Length 2                     Length 3                    Length 4
```

505

T#3 H ▒▒ ───────── Length 5 ─────────► ▒▒

```
 0 | 0 | 1 |   Reserve
         Length 5
```

# FIG.15

504 — MAC SDU #n+2

MAC SDU #n+1 — 503

MAC SDU #n — 502

SDU concatenation and segmentation

BSL (Basic SDU Length)=Lmax × K

CL (Concatenation Length)

Padding

H H H

MAC SDU #n | MAC SDU #n+1 | MAC SDU #n+2 | Short region for BSL
(502) | (503) | (504)

RDT SDU

Encode

CP Size

SP | SP | SP | SP          SP | SP | SP | SP          PP | PP | PP

CRC Attachement

CRC                    CRC                         CRC

SP | SP | SP | SP          SP | SP | SP | PP          PP | PP

CRC          MAC Fragmentation                CRC

Fragment                              Fragment

CRC                                  CRC

| Generic MAC Header | Grant Management SH(UL Only) | Fragment Sub Header | RDT Sub Header | CRC | Payload (One RDT SDU or RDT SDU fragment) |

| Generic MAC Header | Grant Management SH(UL Only) | Fragment Sub Header | RDT Sub Header | CRC | Payload (One RDT SDU or RDT SDU fragment) |

CP: CODED PACKET (GENERAL TERM FOR INFORMATION PACKET AND REDUNDANCY PACKET)
SP: INFORMATION PACKET (SYSTEM PACKET)
PP: REDUNDANCY PACKET (PARITY PACKET)

K: NUMBER OF INFORMATION PACKETS; VALUE OF K IS DETERMINED BASED ON CONFIGURATION OR NEGOTIATION USING CONTROL SIGNAL

Padding Length = $(\lceil CL/K \rceil \times K) - CL$

CP Size = $\lceil CL/K \rceil$

# FIG.16

| Syntax | Size | Notes |
|---|---|---|
| Fragmentation Subheader ( ){ | | |
| FC | 2 bits | Indicates the fragmentation state of the payload<br>00= no fragment<br>01= last fragment<br>10= first fragment<br>11= continuing (middle) fragment |
| if(ARQ-enabled Connection) | | |
| BSN | 11 bits | Sequence number of first block in the current SDU fragment. |
| else if (RDT enabled Connection) | | |
| GSN | 6 bits | Group Sequence number of first block in the Coded Packet |
| reserved | 5 bits | – |
| else { | | |
| if (Type bit Extended Type) | | See Table 6 |
| FSN | 11 bits | Sequence number of the current SDU fragment. This field shall increment by one (modulo 2048) for each fragment, including unfragmented SDUs. |
| else | | |
| FSN | 3 bits | Sequence number of the current SDU fragment. This field shall increment by one ( modulo 8) for each fragment, including unfragmented SDUs. |
| } | | |
| reserved | 3 bits | |
| } | | |

# FIG.17

| Syntax | Size | Notes |
|---|---|---|
| Packing Subheader ( ){ | | |
| FC | 2 bits | Indicates the fragmentation state of the payload<br>00= no fragment<br>01= last fragment<br>10= first fragment<br>11= continuing(middle)fragment |
| if(ARQ - enabled Connection) | | |
| BSN | 11 bits | Sequence number of first block in the current SDU fragment. |
| else if (RDT enabled Connection) | | |
| GSN | 6 bits | Group Sequence number of first block in the Coded Packet |
| reserved | 5 bits | - |
| else { | | |
| if (Type bit Extended Type) | | See Table 6 |
| FSN | 11bits | Sequence number of the current SDU fragment. This field shall increment by one (modulo 2048) for each fragment, including unfragmented SDUs. |
| else | | |
| FSN | 3 bits | Sequence number of the current SDU fragment. This field shall increment by one ( modulo 8) for each fragment, including unfragmented SDUs. |
| } | | |
| Length | 11bits | Length of the SDU fragment in bytes including packing subheader. |
| } | | |

# FIG.18

| Syntax | Size | Notes |
|---|---|---|
| RDT Subheader ( ){ | | |
| CPN | 11 bits | Sequence number of first block in the CP. |
| Coded Packet Size | 10 bits | The size of CP (Coded Packet) |
| reserved | 3 bits | — |
| } | | |

# FIG.19

| Syntax | Size | Notes |
|---|---|---|
| RDT_Feedback_Payload _Format(){ | | |
| do | | |
| RDT_Feedback_IE (last) | variable | Insert as many as desired, until last == TRUE. |
| until (last) | | |
| } | | |

# FIG.20

| Syntax | Size | Notes |
|---|---|---|
| RDT_Feedback_IE(Last){ | Variable | |
| CID | 16 bits | The ID of the connection being referenced |
| LAST | 1 bit | 0=More RDT feedback IE in the list<br>1=Last ARQ feedback IE in the list |
| Reserved | 1 bit | |
| BGSN | 6 bits | Basic Group Sequence Number |
| Number of Active bits | 4 bits | 0x0=1, 0x1=2, 0x2=3, · · · · 0x0F=16 |
| Reserved | 4 bits | |
| ACK MAP | 16 bits | Each bit set to one indicates the corresponding RDT SDU has been decoded successfully. The bit corresponding to the BGSN is MSB of this map. |
| For (i=0; i<Number of NACK; ++i) { | | |
| Received CP Number | 16 bits | Indicate the Received CP number for the RDT SDU with "gnot succeeded" h Group SN. |
| } | | |
| } | | |

# FIG.21

TX      RX

GSN: m    ×

START TIMER
(S101)

GSN: m  Last segment    ×

SUCCESSFULLY
DECODED

GSN: m+1

SQ101

RDT_FB_TIMEOUT

RDT Feedback IE    ×

GSN m: NG

SQ104

RDT Feedback IE

GSN m: NG

(S104)
TIMER EXPIRES

×

GSN: m

SUCCESSFULLY
DECODED

START TIMER
(S102)

GSN: m  Last segment

SUCCESSFULLY
DECODED

SQ102

RDT_FB_TIMEOUT

RDT Feedback IE

GSN m: NG
GSN m+1: OK

SQ103

STOP TIMER
(S103)

GSN: m+1  Last segmen

GSN: m+2

# FIG.22

MAC SDU

Assemble

RDT SDU  CH

Concatenation Header

Concatenation Header

Decode

| SP | SP | SP | SP | SP | SP | SP | SP | SP | SP | SP | SP | SP | SP | SP | SP |   | SP |   +   | PP | PP | PP | PP | PP | PP | PP | PP |

NG

JUDGE CRC  . . .

JUDGE CRC

| SP | SP | | SP | SP | | SP | SP | | SP | SP | | SP | SP | | SP | SP | | SP | SP | |   | PP | PP | | PP | PP | | PP | PP | | PP | PP | |

MAC Header

MH

MAC PDU

MH

MAC PDU

MH

MAC PDU

TRANSMITTED ADDITIONALLY

MH

MAC PDU

MH

MAC PDU

EP 1 962 450 A1

# FIG.23

# FIG.24

| | 301BS | | 302RS | | 303MS | |
|---|---|---|---|---|---|---|
| 601 | Convergence | | | | Convergence | 691 |
| 611 | Upper-MAC | | | | MAC | 681 |
| 612 | ARQ | | | | ARQ | 682 |
| 613 | MAC PDU Framing | | | | MAC PDU Framing | 683 |
| 614 | Ciphpering | | | | Ciphpering | 684 |
| 621 | Lower-MAC | | MAC | 651 | | |
| 622 | Frame Aggregation | | Frame Aggregation | 652 | | |
| 623 | RDT with ECC | | RDT with ECC | 653 | PHY | |
| 624 | MAC PDU Framing | | MAC PDU Framing | 654 | | |
| 631 | PHY | | PHY | | PHY | |
| | | | 641 | 661 | 671 | |

FIG.25

EP 1 962 450 A1

# INTERNATIONAL SEARCH REPORT

| International application No. |
| --- |
| PCT/JP2006/321825 |

**A. CLASSIFICATION OF SUBJECT MATTER**
*H04L1/00*(2006.01)i, *H03M13/47*(2006.01)i, *H04L1/18*(2006.01)i

According to International Patent Classification (IPC) or to both national classification and IPC

**B. FIELDS SEARCHED**

Minimum documentation searched (classification system followed by classification symbols)
H04L1/00, H03M13/47, H04L1/18

| Documentation searched other than minimum documentation to the extent that such documents are included in the fields searched |
| --- |
| Jitsuyo Shinan Koho  1922-1996  Jitsuyo Shinan Toroku Koho  1996-2006 |
| Kokai Jitsuyo Shinan Koho  1971-2006  Toroku Jitsuyo Shinan Koho  1994-2006 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X | JP 2004-517534 A  (Intel Corp.), | 1,8,14,15,17 |
| Y | 10 June, 2004 (10.06.04), | 2-6,9-13,16, |
| | Abstract; Par. Nos. [0003], [0007] to [0015] | 18-28 |
| A | & WO 2002/052862 A2    & US 2002/0080802 A1 | 7,29-31 |
| | & TW 552783 A        & KR 3064867 A | |
| | & EP 1346578 A2      & CN 1483289 A | |
| | | |
| Y | JP 11-136220 A  (Toshiba Corp.), | 2-5,11-13, |
| | 21 May, 1999 (21.05.99), | 16,18,21-28 |
| | Par. Nos. [0090] to [0097], [0102], [0103], | |
| | [0128], [0138] to [0147]; Figs. 7 to 9 | |
| | & US 2003/0005387 A1 | |
| | | |
| Y | JP 2002-9832 A  (Fujitsu Ltd.), | 5,20,21 |
| | 11 January, 2002 (11.01.02), | |
| | Abstract; Claim 1; Par. Nos. [0004], [0037] | |
| | & US 2001/0055317 A1 | |

| ☒ Further documents are listed in the continuation of Box C. | ☐ See patent family annex. |
| --- | --- |

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 20 December, 2006 (20.12.06) | 09 January, 2007 (09.01.07) |

| Name and mailing address of the ISA/ | Authorized officer |
| --- | --- |
| Japanese Patent Office | |
| Facsimile No. | Telephone No. |

Form PCT/ISA/210 (second sheet) (April 2005)

**INTERNATIONAL SEARCH REPORT**

| | International application No. |
|---|---|
| | PCT/JP2006/321825 |

C (Continuation).   DOCUMENTS CONSIDERED TO BE RELEVANT

| Category* | Citation of document, with indication, where appropriate, of the relevant passages | Relevant to claim No. |
|---|---|---|
| Y | JP 11-502989 A  (Seiko Communications Systems, Inc.), 09 March, 1999 (09.03.99), Abstract; Claim 1 & EP 818087 A1          & US 5602831 A & AU 5305196 A          & WO 1996/031020 A1 | 6 |
| Y | JP 9-55776 A  (Kokusai Denshin Denwa Co., Ltd. (KDD)), 25 February, 1997 (25.02.97), Abstract; Par. Nos. [0011], [0021] (Family: none) | 9-13,22-28 |
| Y | JP 2005-065335 A  (Mitsubishi Electric Corp.), 10 March, 2005 (10.03.05), Par. Nos. [0066], [0067] & CN 1520700 A          & EP 1443784 A1 & US 2005/0025188 A1     & WO 2003/041437 A1 | 13 |
| Y | JP 10-262033 A  (Toshiba Corp.), 29 September, 1998 (29.09.98), Abstract; Par. No. [0014] (Family: none) | 19 |
| A | JP 8-32623 A  (Toshiba Corp.), 02 February, 1996 (02.02.96), Claim 2 & US 5699519 A          & KR 155457 B1 & EP 693839 A2          & DE 69527006 E | 29,30 |
| A | JP 2005-039328 A  (Matsushita Electric Industrial Co., Ltd.), 10 February, 2005 (10.02.05), Claim 1; Par. Nos. [0006], [0007] (Family: none) | 7 |

Form PCT/ISA/210 (continuation of second sheet) (April 2005)